# EUROPEAN PATENT APPLICATION

(11) **EP 4 646 084 A1**
(43) Date of publication of application: **05.11.2025**
(21) Application number: 25172420.9
(22) Date of filing: 24.04.2025
(51) Int. Cl.: H10K 59/38

(54) **DISPLAY DEVICE AND ELECTRONIC DEVICE**

(30) Priority: 03.05.2024 KR 20240059008
(71) Applicant: Samsung Display Co., Ltd., Gyeonggi-Do (KR)
(72) Inventor: KWON, Youngsoo, Yongin-si (KR); SONG, Taeyoung, Yongin-si (KR); YOON, Won-Gap, Yongin-si (KR); LEE, Kiheon, Yongin-si (KR)
(74) Representative: Marks & Clerk LLP

(57) **Abstract**

A display device is disclosed. The display device may include a light-emitting element that outputs source light and a light control layer on the light-emitting element, which transmits the source light or converts the wavelength of the source light. The light-emitting element may include a first electrode, a second electrode facing (e.g., opposite to) the first electrode, at least one green light-emitting structure between the first electrode and the second electrode, and at least one blue light-emitting structure between the first electrode and the second electrode. The light control layer may include a green light control part including a green quantum dot that converts the wavelength of light emitted from the light-emitting element and emits green light. The power conversion efficiency of the green light control part may be less than about 32%, thereby being able to exhibit or provide excellent or suitable light efficiency and relatively high luminance characteristics.

## Description

### BACKGROUND

### 1. Field

One or more embodiments of the present disclosure relate to a display device, and, for example, to a display device including a light control layer including quantum dots.

One or more embodiments of the present disclosure relate to an electronic device including the display device.

### 2. Description of the Related Art

Display devices include a transmissive display device that selectively transmits source light generated from a light source and a light-emitting display device that generates source light within the display device itself. Display devices may include different types or kinds of light control units depending on pixels to generate a color image. The light control units may transmit only a certain wavelength range of source light or change the color of source light. One or more suitable light control units may change the characteristics of light without changing the color of source light.

A quantum dot material and/or the like is used in a light control unit of a display device, and in order to improve or enhance the display quality of a display device, it is desired or required to develop technology to increase or enhance power conversion efficiency and/or light transmission efficiency in a light control unit.

### SUMMARY

One or more aspects of embodiments of the present disclosure are directed toward a display device having excellent or suitable light extraction efficiency.

One or more aspects of embodiments of the present disclosure are also directed toward a display device having improved or enhanced light efficiency for green light.

Additional aspects of embodiments will be set forth in part in the description which follows and, in part, will be apparent from the description or may be learned by practice of the presented embodiments of the disclosure.

One or more embodiments of the present disclosure provide a display device that includes a light-emitting element that outputs source light and a light control layer on the light-emitting element, wherein the light control layer transmits the source light or converts the wavelength of the source light, wherein the light-emitting element includes a first electrode, a second electrode facing (e.g., opposite to) the first electrode, at least one green light-emitting structure between the first electrode and the second electrode, and at least one blue light-emitting structure between the first electrode and the second electrode, wherein the light control layer includes a green light control unit including a green quantum dot that converts the wavelength of light emitted from the light-emitting element and emits green light, wherein the power conversion efficiency of the green light control unit is less than about 32%, and the power conversion efficiency is a conversion efficiency at the maximum light-emitting peak wavelength of light emitted by exciting the green quantum dot with light of a wavelength of about 450 nm.

In one or more embodiments, the green quantum dot may be a multicomponent quantum dot including silver (Ag), indium (In), gallium (Ga), and/or sulfur (S).

In one or more embodiments, the green quantum dot may be AgIn_{X}Ga_{1-X}S₂, wherein 0.05≤X<1.

In one or more embodiments, the light-emitting center wavelength of the green light converted and emitted by the green quantum dot may be about 500 nm to about 590 nm, and a light-emitting full width of half maximum may be about 40 nm or less.

In one or more embodiments, the average diameter of the green quantum dot may be about 3 nm or more.

In one or more embodiments, each of the at least one green light-emitting structure and the at least one blue light-emitting structure may include a hole transport region, a light-emitting layer, and an electron transport region, and the light-emitting element may further include a charge generation layer between the at least one green light-emitting structure and the at least one blue light-emitting structure.

In one or more embodiments, the light-emitting element may include a first light-emitting structure, a second light-emitting structure, a third light-emitting structure, a fourth light-emitting structure, and a fifth light-emitting structure that are sequentially provided in the direction of the light control layer and charge generation layers that are provided between the first light-emitting structure, the second light-emitting structure, the third light-emitting structure, the fourth light-emitting structure, and the fifth light-emitting structure, which are provided between the first electrode and the second electrode, and at least one selected from among the first light-emitting structure, the second light-emitting structure, the third light-emitting structure, the fourth light-emitting structure, and the fifth light-emitting structure may be a green light-emitting structure, and the remaining light-emitting structures may be blue light-emitting structures.

In one or more embodiments, the thickness of the green light control unit may be about 2 µm to about 15 µm.

In one or more embodiments, the content (e.g., amount) of the green quantum dot in the green light control unit may be about 1 wt% to about 20 wt%.

One or more embodiments of the present disclosure provide a display device that includes a display layer that provides source light including light-emitting green light and light-emitting blue light and a light control layer on the display layer, wherein the light control layer includes a first light control unit, a second light control unit, and a third light control unit that are divided from each other on a plane (e.g., in a plan view), wherein the first light control unit includes a red quantum dot that converts the wavelength of the source light into converted red light, and the second light control unit includes a green quantum dot that converts the wavelength of the source light into converted green light, wherein the power conversion efficiency of the second light control unit is less than about 32%, and the power conversion efficiency is a conversion efficiency at the maximum light-emitting peak wavelength of light emitted by exciting the green quantum dot with light of a wavelength of about 450 nm.

In one or more embodiments, the green quantum dot may be AgIn_{X}Ga_{1-X}S₂, wherein 0.05≤X<1.

In one or more embodiments, the content (e.g., amount) of the green quantum dot in the second light control unit may be about 1 wt% to about 20 wt%.

In one or more embodiments, the thickness of the second light control unit may be about 2 µm to about 15 µm.

In one or more embodiments, the red quantum dot may include indium (In) and phosphorus (P).

In one or more embodiments, the display layer may include a light-emitting element including at least one green light-emitting layer that emits the light-emitting green light and at least one blue light-emitting layer that emits the light-emitting blue light, which may be stacked in a thickness direction.

In one or more embodiments, the third light control unit may transmit the source light and may not include a quantum dot.

In one or more embodiments, light emitted from the second light control unit may include the converted green light and the light-emitting green light.

One or more embodiments of the present disclosure provide an electronic device, which includes a red light-emitting region, a green light-emitting region, and a blue light-emitting region that are divided from each other on a plane (e.g., in a plan view), includes: a display panel including a light-emitting element that includes a green light-emitting structure and a blue light-emitting structure stacked in a thickness direction and emits source light; and a light control panel on the display panel, wherein the light control panel includes a light control layer which includes a first light control unit that corresponds to the red light-emitting region, a second light control unit that corresponds to the green light-emitting region, and a third light control unit that corresponds to the blue light-emitting region, wherein the second light control unit converts the wavelength of the source light or transmits the source light and emits green light, the power conversion efficiency of the second light control unit is less than about 32%, and the power conversion efficiency is a conversion efficiency at the maximum light-emitting peak wavelength of light wavelength-converted and emitted by exciting the green quantum dot with light of a wavelength of about 450 nm.

In one or more embodiments, the second light control unit may include a green quantum dot having a chemical formula of AgIn_{X}Ga_{1-X}S₂, wherein 0.05≤X<1.

In one or more embodiments, the light control panel may further include a color filter layer above the light control layer.

The electronic device may be a smartphone, a television, a monitor, a tablet, an electric vehicle, a mobile phone, a tablet personal computer (PC), a mobile communication terminal, an electronic notebook, an electronic book, a portable multimedia player (PMP), a navigation device, an ultra-mobile PC (UMPC), a laptop computer, a billboard, an Internet of Things (IoT) device, a smartwatch, a watch phone, and/or a head-mounted display (HMD).

At least some of the above and other features of the invention are set out in the claims.

### BRIEF DESCRIPTION OF THE DRAWINGS

The accompanying drawings are included to provide a further understanding of embodiments of the subject matter of the present disclosure and are incorporated in and constitute a part of this specification. The drawings illustrate embodiments of the subject matter of the present disclosure and, together with the description, serve to explain principles of embodiments of the subject matter of the present disclosure. In the drawings:
FIG. 1 is a perspective view of a display device according to one or more embodiments of the present disclosure;
FIG. 2 is a cross-sectional view of the display device according to one or more embodiments of the present disclosure;
FIG. 3 is a plan view of the display device according to one or more embodiments of the present disclosure;
FIG. 4 is an enlarged plan view of a portion of the display device according to one or more embodiments of the present disclosure;
FIG. 5 is a cross-sectional view of a portion of the display device according to one or more embodiments of the present disclosure;
FIG. 6A is a cross-sectional view of a portion of the display device according to one or more embodiments of the present disclosure;
FIG. 6B is a cross-sectional view of a portion of a display device according to one or more embodiments of the present disclosure;
FIG. 6C is a cross-sectional view of a portion of a display device according to one or more embodiments of the present disclosure;
FIG. 7 is a cross-sectional view of a light-emitting element according to one or more embodiments of the present disclosure;
FIG. 8A is a cross-sectional view of a light-emitting structure according to one or more embodiments of the present disclosure;
FIG. 8B is a cross-sectional view of a light-emitting structure according to one or more embodiments of the present disclosure;
FIG. 9 is a cross-sectional view of a light-emitting element according to one or more embodiments of the present disclosure;
FIG. 10 is a cross-sectional view of a light control layer according to one or more embodiments of the present disclosure;
FIG. 11 is a diagram schematically illustrating light extraction characteristics in a display device according to one or more embodiments of the present disclosure;
FIG. 12A is a graph illustrating light efficiency according to the thickness of a light control layer;
FIG. 12B is a graph illustrating light efficiency according to power conversion efficiency;
FIG. 13A is a graph illustrating light efficiency according to the content (e.g., amount) of quantum dots; and
FIG. 13B is a graph illustrating light efficiency according to power conversion efficiency.

### DETAILED DESCRIPTION

In the present disclosure, one or more suitable modifications may be made, one or more suitable forms may be used, and particular embodiments will be illustrated in the drawings and described in more detail. However, it is not intended to limit the present disclosure to the particular forms disclosed, and it will be understood that all changes, equivalents, or substitutes which fall within the scope of the present disclosure should be included.

The same reference numerals are used for substantially the same components or elements in the drawings, and redundant descriptions of substantially the same components or elements may not be provided.

In the present disclosure, it will be understood that if (e.g., when) an element (or a region, a layer, a portion, and/or the like) is referred to as being "on", "connected to", or "coupled to" another element, it may be directly on, directly connected to, or directly coupled to the other element, or intervening elements may be present between the elements. In contrast, if (e.g., when) an element is referred to as being "directly on" another element, there may be no intervening elements present.

Like reference numerals refer to like elements throughout. In addition, in the drawings, the thicknesses, the ratios, and the dimensions of elements may be exaggerated for effective description of the technical contents. As used herein, the term "and/or" includes any and all combinations that the associated configurations or arrangements can define.

It will be understood that, although the terms "first," "second," and/or the like may be used herein to describe one or more elements, these elements should not be limited by these terms. These terms are only used to distinguish one element from another element. For example, a first element could be termed a second element without departing from the scope of the present disclosure. Similarly, the second element may also be referred to as the first element. The terms of a singular form include plural forms unless otherwise specified.

In one or more embodiments, terms, such as "below", "lower", "above", "upper", and/or the like, are used herein for ease of description to describe one element's relation to another element(s) as illustrated in the drawings. The above terms are relative concepts and are described based on the directions indicated in the drawings.

It will be understood that the terms "include/including" and/or "has/have/having", if (e.g., when) used in the present disclosure, specify the presence of stated features, integers, steps, acts, operations, elements, components, and/or groups thereof, but do not preclude the presence or addition of one or more other features, integers, steps, acts, operations, elements, components, and/or groups thereof. Also, the terms "comprise(s)/comprising," "include(s)/including," "have/has/having" or similar terms include or support the terms "consisting of" and "consisting essentially of," indicating the presence of stated features, integers, steps, acts, operations, elements, and/or components, without or essentially without the presence of other features, integers, steps, acts, operations, elements, components, and/or groups thereof.

In the present disclosure, being "directly disposed", "directly provided", and/or the like may refer to that there is no layer, film, region, plate, and/or the like added between a part, such as a layer, a film, a region, or a plate and another part, such as a layer, a film, a region, or a plate. For example, being "directly disposed", "directly provided", and/or the like may refer to that no additional member, such as an adhesive member, is between two layers or two members.

Unless otherwise defined, all terms (including technical and scientific terms) used herein have substantially the same meaning as commonly understood by one of ordinary skill in the art to which this disclosure belongs. It will be further understood that terms, such as those defined in dictionaries that are generally available or generally used, should be interpreted as having a meaning that is consistent with their meaning in the context of the relevant art and will not be interpreted in an idealized or overly formal sense unless expressly so defined herein.

Hereinafter, a display device and an electronic device including the display device according to one or more embodiments of the present disclosure will be described with reference to the accompanying drawings.

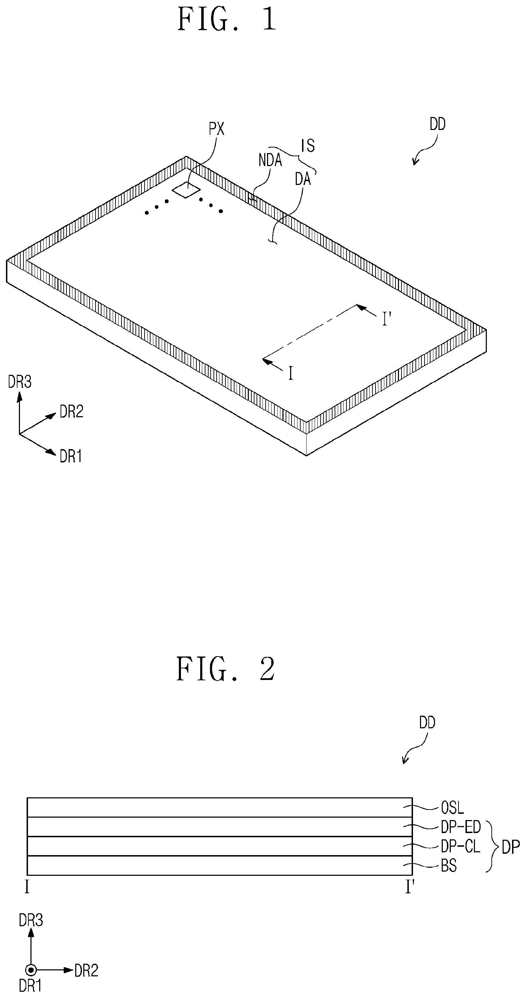

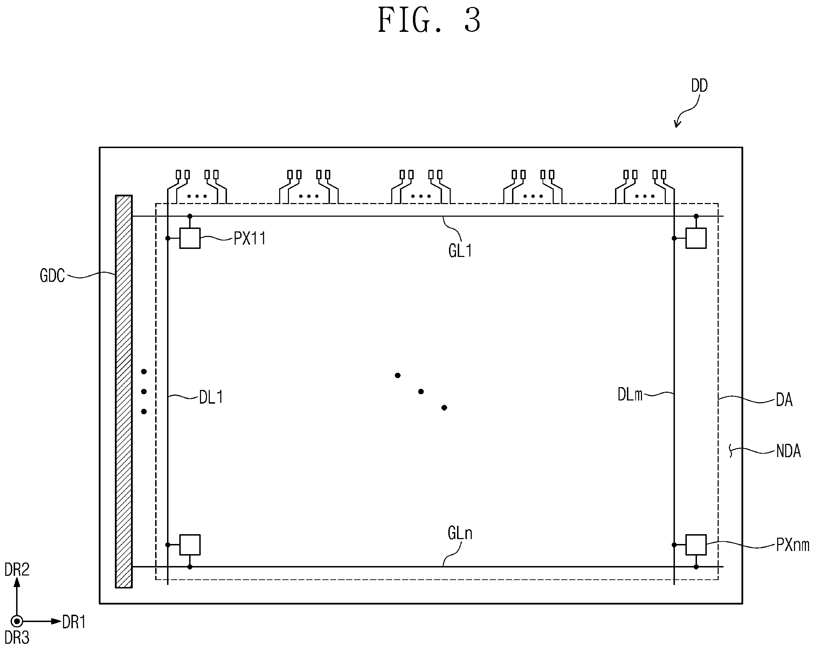

FIG. 1 is a perspective view of a display device according to one or more embodiments of the present disclosure. FIG. 2 is a cross-sectional view of the display device according to one or more embodiments of the present disclosure. FIG. 3 is a plan view of the display device according to one or more embodiments of the present disclosure. FIG. 2 may be a cross-sectional view that corresponds to the line I-I' of FIG. 1.

The display device DD according to one or more embodiments of the present disclosure may be activated according to an electrical signal and display an image. In the present disclosure, the display device may be referred to as an electronic device, or the display device may be included in an electronic device that is activated by an electrical signal. For example, the display device DD or the electronic device may be not only a large-sized device, such as a television and an external billboard, but also a small or medium-sized device, such as a monitor, a mobile phone, a tablet, a navigation system, and a game console. However, one or more embodiments of the display device DD are examples, and the examples of the display device are not limited to any one of the embodiments as long as they do not depart from the scope of the present disclosure.

The display device DD may be rigid or flexible. The expression "being flexible" refers to a property of being bendable. For example, a flexible display device DD may include a curved device, a rollable device, and/or a foldable device.

In one or more embodiments, in FIG. 1 and following drawings, a first direction axis DR1 to a third direction axis DR3 are illustrated, and directions indicated by the first direction axis DR1, the second direction axis DR2, and the third direction axis DR3 described in the present disclosure are relative concepts and may be converted into other directions. In one or more embodiments, the directions indicated by the first direction axis DR1, the second direction axis DR2, and the third direction axis DR3 may be described as a first direction, a second direction, and a third direction, and the same reference numerals may be used for the first direction, the second direction, and the third direction.

The thickness direction of the display device DD may be substantially parallel to the third direction axis DR3 which is a normal direction with respect to a plane defined by the first direction axis DR1 and the second direction axis DR2. In the present disclosure, the front surfaces (or upper surfaces) and the rear surfaces (or lower surfaces) of members that constitute the display device DD may be defined based on the third direction axis DR3. The front (or upper) and rear (or lower) surfaces of each member that constitute the display device DD may be opposed to (e.g., facing) each other in the third direction DR3, and the normal direction of each of the front surfaces and the rear surfaces may be substantially parallel to the third direction DR3. The separation distance between the front surfaces and the rear surfaces defined along the third direction DR3 may correspond to the thickness of a member.

In the present disclosure, the expression "on a plane" may be defined as viewed in the third direction DR3 (e.g., in a plan view). In the present disclosure, the expression "on a cross section" may be defined as viewed in the first direction DR1 or the second direction DR2. In one or more embodiments, directions indicated by the first direction DR1, the second direction DR2, and the third direction DR3 are relative concepts and may be converted into other directions.

The display device DD according to one or more embodiments of the present disclosure may display an image through a display surface IS. The display surface IS may include a plane defined by the first direction DR1 and the second direction DR2. The display surface IS may include a display region DA and a non-display region NDA. A pixel PX may be in the display region DA and may not be in the non-display region NDA. The non-display region NDA may be defined along the edge of the display surface DP-IS. The non-display region NDA may surround (e.g., may be around) the display region DA. Without being limited thereto, however, in one or more embodiments, the non-display region NDA may not be provided or may be only on one side of the display region DA.

In one or more embodiments, although the display device DD having a flat display surface IS is illustrated, embodiments of the present disclosure are not limited thereto. The display device DD may include a curved display surface or a three-dimensional display surface. The three-dimensional display surface may include a plurality of display regions that indicate different directions.

Referring to FIG. 2, the display device DD according to one or more embodiments of the present disclosure may include a display panel DP and a light control panel OSL on the display panel DP. The display panel DP may include a base layer BS, a circuit layer DP-CL, and a display layer DP-ED sequentially stacked in the third direction DR3. The light control panel OSL may be on the display layer DP-ED.

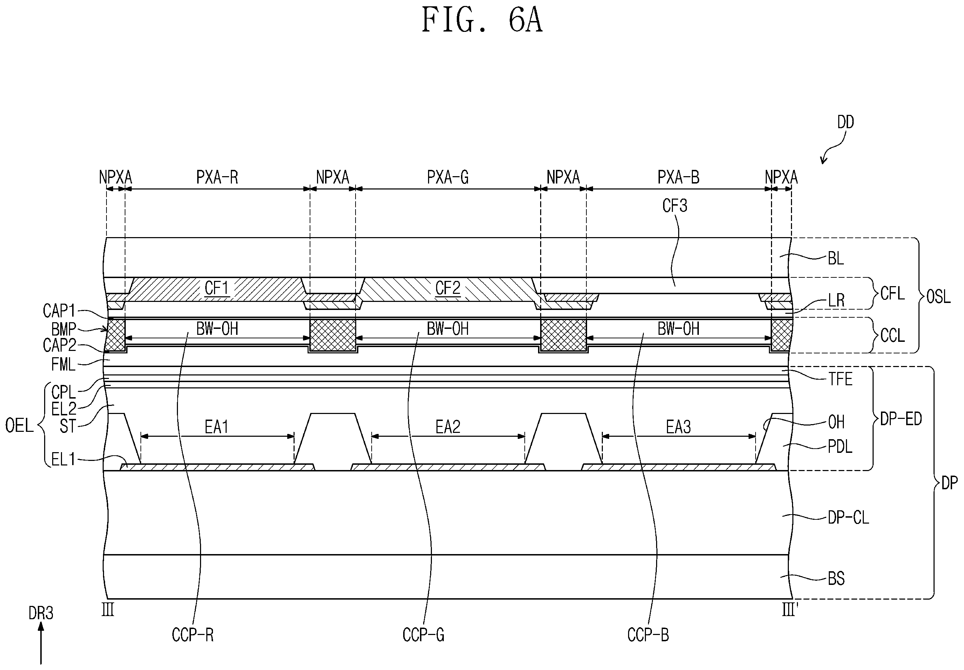

In one or more embodiments, a filling layer FML (see FIG. 6A) may be between the display panel DP and the light control panel OSL. The display panel DP and the light control panel OSL may be disposed or provided to be spaced and/or apart (e.g., spaced apart or separated) from each other with the filling layer FML (see FIG. 6A) therebetween. In one or more embodiments, the light control panel OSL may be manufactured in a separate process step or act and then provided on the display panel DP.

In one or more embodiments, in the display device DD according to one or more embodiments of the present disclosure, the light control panel OSL may be directly on the display layer DP-ED. In the present disclosure, an expression "one component is disposed/provided directly on another component" refers to that a third component is not between them. For example, the expression "one component is disposed/provided directly on another component" refers to that one component is in contact with another component.

In one or more embodiments, the display panel DP may be referred to as a lower panel or a lower display substrate, and the light control panel OSL may be referred to as an upper panel or an upper display substrate.

In the display device DD according to one or more embodiments of the present disclosure, the base layer BS may be a support substrate on which the circuit layer DP-CL and the display layer DP-ED are provided. The circuit layer DP-CL may include at least one insulating (e.g., electrically insulating) layer and a circuit element. The circuit element may include a signal line, a pixel driving circuit, and/or the like. The circuit layer DP-CL may be formed or provided through a process of forming or providing an insulating (e.g., electrically insulating) layer, a semiconductor layer, and a conductive (e.g., electrically conductive) layer by coating, deposition, and/or the like, and then a process of patterning the insulating (e.g., electrically insulating) layer, the semiconductor layer, and the conductive (e.g., electrically conductive) layer by a photolithography method.

The display layer DP-ED may include a display element. The display element may include a light-emitting element that generates light and provides the generated light to the light control panel OSL. The display panel DP including the display layer DP-ED may provide source light to the light control panel OSL disposed or provided above.

The light control panel OSL may convert the wavelength of light provided from the display panel DP or transmit a portion of the provided light. The light control panel OSL may include a light control unit that converts the wavelength of light or transmits light and structures for increasing or enhancing the conversion efficiency of emitted light.

FIG. 3 illustrates the planar arrangement relationship of signal lines GL1 to GLn and DL1 to DLm and pixels PX11 to PXnm. The signal lines GL1 to GLn and DL1 to DLm may include a plurality of gate lines GL1 to GLn and a plurality of data lines DL1 to DLm.

Each of the pixels PX11 to PXnm may be connected to a corresponding gate line among the plurality of gate lines GL1 to GLn and a corresponding data line among the plurality of data lines DL1 to DLm. Each of the pixels PX11 to PXnm may include a pixel driving circuit and a display element. According to the configuration or arrangements of the pixel driving circuit of the pixels PX11 to PXnm, more types or kinds of signal lines may be provided on the display panel DP.

Although FIG. 3 illustrates, as an example, matrix-type or -kind pixels PX11 to PXnm, embodiments of the present disclosure are not limited thereto. The pixels PX11 to PXnm may be in a Pentile^{®} shape. For example, points at which the pixels PX11 to PXnm are disposed or provided may correspond to the vertices of a diamond. The gate driving circuit GDC may be integrated into the display device DD through an oxide silicon gate driver circuit (OSG) process and/or an amorphous (e.g., non-crystalline) silicon gate driver circuit (ASG) process.

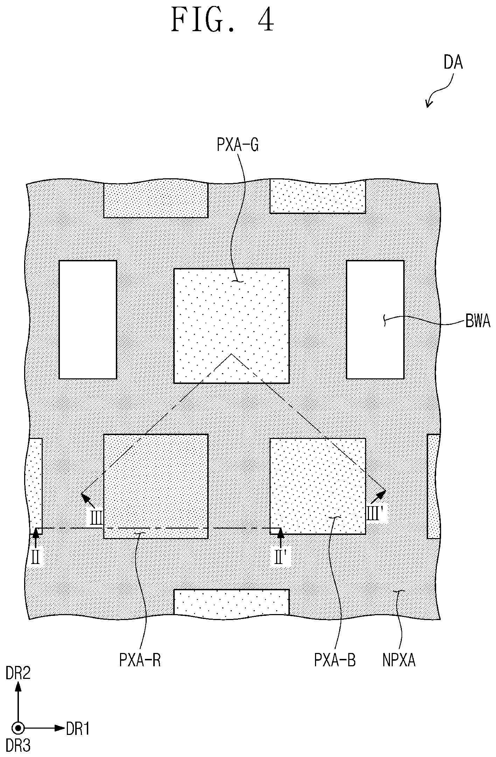

FIG. 4 is an enlarged plan view of a portion of a display region in the display device according to one or more embodiments of the present disclosure.

FIG. 4 illustrates, as an example, a plane when the display device DD (see FIG. 1) according to one or more embodiments of the present disclosure includes three pixel regions PXA-R, PXA-G, and PXA-B and bank well regions BWA adjacent thereto. In one or more embodiments, the three types or kinds of pixel regions PXA-R, PXA-G, and PXA-B as illustrated in FIG. 4 may be repeatedly disposed or provided throughout the display region DA. The pixel regions PXA-R, PXA-G, and PXA-B may also be called or referred to as light-emitting regions. In one or more embodiments, the bank well region BWA may not be provided.

In one or more embodiments, the display device DD (see FIG. 1) may include a first pixel region PXA-R, a second pixel region PXA-G, and a third pixel region PXA-B that emit light in different wavelength ranges. The first pixel region PXA-R, the second pixel region PXA-G, and the third pixel region PXA-B may be spaced and/or apart (e.g., spaced apart or separated) from each other without overlapping each other if (e.g., when) viewed on a plane (e.g., in a plan view).

In one or more embodiments, the first pixel region PXA-R may be a red light-emitting region that emits red light, the second pixel region PXA-G may be a green light-emitting region that emits green light, and the third pixel region PXA-B may be a blue light-emitting region that emits blue light. However, embodiments of the present disclosure are not limited thereto, and in one or more embodiments, the display region DA may further include a pixel region that emits white light in addition to the first pixel region PXA-R, the second pixel region PXA-G, and the third pixel region PXA-B.

In one or more embodiments, the first pixel region PXA-R may emit light of a light-emitting wavelength of about 610 nm to about 700 nm, the second pixel region PXA-G may emit light of a light-emitting wavelength of about 500 nm to about 590 nm, and the third pixel region PXA-B may emit light of a light-emitting wavelength of about 410 nm to about 480 nm. The first pixel region PXA-R may be referred to as a red pixel region, the second pixel region PXA-G may be referred to as a green pixel region, and the third pixel region PXA-B may be referred to as a blue pixel region.

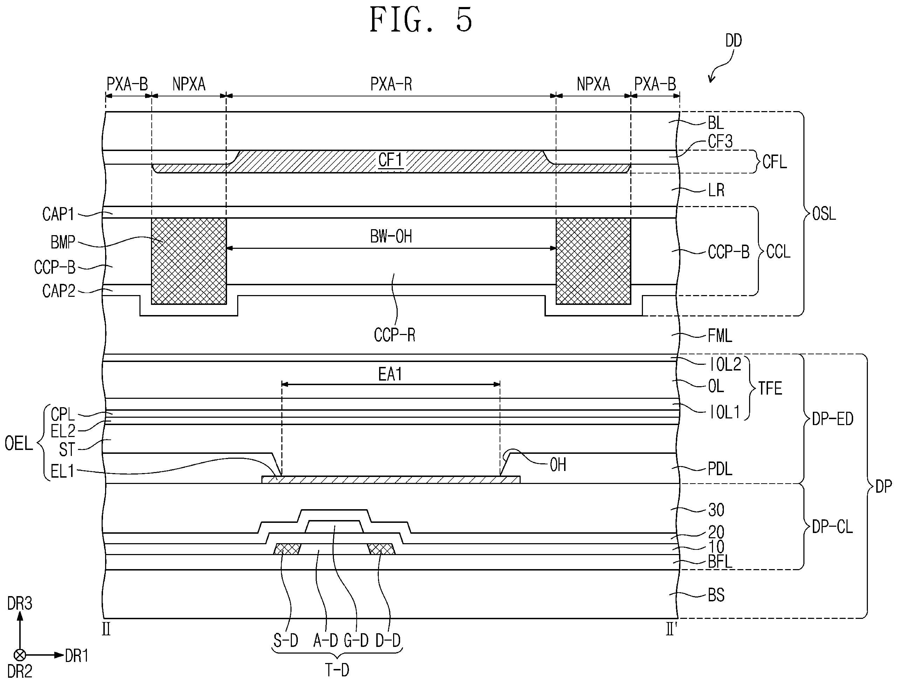

A peripheral region NPXA may be around (or may surround) the first pixel region PXA-R, the second pixel region PXA-G, and the third pixel region PXA-B. The peripheral region NPXA may be referred to as a non-light-emitting region. The peripheral region NPXA may be in a shape of surrounding each of the first pixel region PXA-R, the second pixel region PXA-G, and the third pixel region PXA-B. The peripheral region NPXA may set or predetermine the boundaries of the first pixel region PXA-R, the second pixel region PXA-G, and the third pixel region PXA-B and prevent color mixing (or reduce a degree or occurrence of color mixing) between the first pixel region PXA-R, the second pixel region PXA-G, and the third pixel region PXA-B. A structure, such as a pixel defining film PDL (see FIG. 5) or a division pattern BMP (see FIG. 5), which prevents color mixing (or reduces a degree or occurrence of color mixing) between the first pixel region PXA-R, the second pixel region PXA-G, and the third pixel region PXA-B, may be in the peripheral region NPXA.

FIG. 4 illustrates, as an example, the first pixel region PXA-R, the second pixel region PXA-G, and the third pixel region PXA-B which have substantially similar rectangular (e.g., substantially rectangular) planar shapes and different planar areas, but embodiments of the present disclosure are not limited thereto. The areas of two or more types or kinds of pixel regions among the first pixel region PXA-R, the second pixel region PXA-G, and the third pixel region PXA-B may be substantially the same as each other. The area of each of the first pixel region PXA-R, the second pixel region PXA-G, and the third pixel region PXA-B may be set or predetermined according to the color of emitted light. Among primary colors, the area of the pixel region that emits red light may be the largest, and the area of the pixel region that emits blue light may be the smallest. However, embodiments of the present disclosure are not limited thereto, and the size and/or the like of each pixel region may be adjusted according to color characteristics desired or required for the display device.

FIG. 4 illustrates the first pixel region PXA-R, the second pixel region PXA-G, and the third pixel region PXA-B in a rectangular (e.g., substantially rectangular) shape, but embodiments of the present disclosure are not limited thereto. On a plane (e.g., in a plan view), the first pixel region PXA-R, the second pixel region PXA-G, and the third pixel region PXA-B may have different polygonal shapes (e.g., substantially polygonal shapes), such as rhombuses (e.g., substantially rhombuses) or pentagons (e.g., substantially pentagons). In one or more embodiments, the first pixel region PXA-R, the second pixel region PXA-G, and the third pixel region PXA-B may have rectangular shapes (e.g., substantially rectangular shapes) with rounded corners on a plane (e.g., in a plan view).

FIG. 4 illustrates, as an example, that the second pixel region PXA-G may be in a first row and the first pixel region PXA-R and the third pixel region PXA-B may be in a second row, but without being limited thereto, the arrangement of the first pixel region PXA-R, the second pixel region PXA-G, and the third pixel region PXA-B may be changed in one or more suitable ways. For example, the first pixel region PXA-R, the second pixel region PXA-G, and the third pixel region PXA-B may be in a same row.

A bank well region BWA may be defined in the display region DA. The bank well region BWA may be a region in which a bank well is formed or provided in order to prevent defects (or to reduce a degree or occurrence of defects) due to misplacement in a process of patterning a plurality of light control units CCP-R, CCP-G, and CCP-B (see FIG. 6A) included in a light control layer CCL (see FIG. 6A). For example, the bank well region BWA may be a region in which a bank well formed or provided by removing a portion of a division pattern BMP (see FIG. 6A) is defined.

FIG. 4 illustrates, as an example, that two bank well regions BWA may be defined so as to be adjacent to the second pixel region PXA-G, but without being limited thereto, the shape and/or arrangement of the bank well region BWA may be changed in one or more suitable ways. In one or more embodiments, the bank well may not be defined.

FIG. 5 is a cross-sectional view of a portion of the display device according to one or more embodiments of the present disclosure. FIG. 6A is a cross-sectional view illustrating a partial region of the display device according to one or more embodiments of the present disclosure. FIG. 5 may be a cross-sectional view that corresponds to the line II-II' of FIG. 4, and FIG. 6A may be a cross-sectional view that corresponds to the line III-III' of FIG. 4. Unlike FIG. 5, FIG. 6A illustrates the configuration or arrangements of the circuit layer DP-CL and an encapsulation layer TFE and illustrates a portion of the display device in the plurality of pixel regions.

In one or more embodiments, the display panel DP may include a base layer BS, a circuit layer DP-CL on the base layer BS, and a display layer DP-ED on the circuit layer DP-CL. In one or more embodiments, the display layer DP-ED may include a pixel defining film PDL, a light-emitting element OEL, and an encapsulation layer TFE. The encapsulation layer TFE may cover the upper portion of the light-emitting element OEL.

In the display device DD according to one or more embodiments of the present disclosure, the display panel DP may be a light-emitting display panel. For example, the display panel DP may be an organic electroluminescence display panel. If (e.g., when) the display panel DP is an organic electroluminescence display panel, the display layer DP-ED may include an organic electroluminescence element as a light-emitting element OEL. However, embodiments of the present disclosure are not limited thereto. For example, the display layer DP-ED may include a quantum dot light-emitting element as a light-emitting element OEL. In one or more embodiments, the display layer DP-ED may include a micro LED element and/or a nano LED element as a light-emitting element OEL.

The display panel DP may provide source light. The light-emitting element OEL may generate source light. The source light generated and output from the light-emitting element OEL may be provided to the light control panel OSL, and at least a portion of the source light may be converted into light of a wavelength different from that of the source light in the light control layer CCL of the light control panel OSL, or at least a portion of the source light may be transmitted without wavelength conversion.

In the display panel DP, the base layer BS may be a member that provides a reference surface on which components included in the circuit layer DP-CL are disposed or provided. In one or more embodiments, the base layer BS may be a glass substrate, a metal substrate, a polymer substrate, and/or the like. However, embodiments of the present disclosure are not limited thereto, and the base layer BS may be an inorganic layer, an organic layer, and/or a composite material layer.

The base layer BS may have a multi-layered structure. For example, the base layer BS may have a three-layer structure of a polymer resin layer, an adhesive layer, and a polymer resin layer. For example, the polymer resin layer may include a polyimide-based resin. In one or more embodiments, the polymer resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, or a perylene-based resin. In one or more embodiments, an "α-based" resin refers to including a functional group of "α".

The circuit layer DP-CL may be on the base layer BS. The circuit layer DP-CL may include a transistor T-D as a circuit element. The configuration or arrangement of the circuit layer DP-CL may vary according to the design of the driving circuit of the pixel PX (see FIG. 1). FIG. 5 illustrates one transistor T-D as an example, and the arrangement relationship of an active A-D, a source S-D, a drain D-D, and a gate G-D is illustrated as an example. The active A-D, the source S-D, and the drain D-D may be divided according to the doping concentration or conductivity (e.g., electrical conductivity) of a semiconductor pattern.

The circuit layer DP-CL may include a buffer layer BFL, a first insulating layer 10, a second insulating layer 20, and a third insulating layer 30 above the base layer BS. For example, the buffer layer BFL, the first insulating layer 10, and the second insulating layer 20 may be inorganic layers, and the third insulating layer 30 may be an organic layer.

The display layer DP-ED may include a light-emitting element OEL as a display element. In one or more embodiments, the light-emitting element OEL may be on the third insulating layer 30. The light-emitting element OEL may generate source light. In one or more embodiments, the source light provided from the light-emitting element OEL may include source light in a blue wavelength region and/or source light in a green wavelength region. In one or more embodiments, the source light may include source light in a blue wavelength region, source light in a green wavelength region, and/or source light in a red wavelength region.

The light-emitting element OEL may include a first electrode EL1, a second electrode EL2 facing (e.g., opposite to) the first electrode EL1, and a light-emitting stack ST between the first electrode EL1 and the second electrode EL2. The light-emitting element OEL may further include a capping layer CPL on the second electrode EL2.

In one or more embodiments, the light-emitting stack ST may include two or more light-emitting structures that are divided from each other and stacked in the thickness direction. The light-emitting stack ST may include at least one blue light-emitting structure that emits blue light and at least one green light-emitting structure that emits green light. For example, the light-emitting element OEL according to one or more embodiments of the present disclosure, which includes the light-emitting stack ST, may be a tandem light-emitting element including a plurality of light-emitting layers stacked in the thickness direction.

The first electrode EL1 of the light-emitting element OEL may be directly or indirectly connected to the transistor T-D. The first electrode EL1 may be an anode or a cathode. In one or more embodiments, the first electrode EL1 may be a pixel electrode. The first electrode EL1 may be a transmissive electrode, a semi-transmissive electrode, or a reflective electrode.

The second electrode EL2 may be disposed or provided to face (e.g., to be opposite to) the first electrode EL1 with the light-emitting stack ST therebetween. The second electrode EL2 may be an electrode that is generally available or generally used. The second electrode EL2 may be a cathode or an anode, but embodiments of the present disclosure are not limited thereto. For example, if (e.g., when) the first electrode EL1 is an anode, the second electrode EL2 may be a cathode, and if (e.g., when) the first electrode EL1 is a cathode, the second electrode EL2 may be an anode. The second electrode EL2 may be a transmissive electrode, a semi-transmissive electrode, or a reflective electrode.

The light-emitting element OEL included in the display device DD according to one or more embodiments of the present disclosure will be described in more detail herein.

The display layer DP-ED may include a pixel defining film PDL. For example, the pixel defining film PDL may be an organic layer. A light-emitting opening OH may be defined in the pixel defining film PDL. The light-emitting opening OH of the pixel defining film PDL may expose at least a portion of the first electrode EL1. In one or more embodiments, light-emitting regions EA1, EA2, and EA3 may be defined by the light-emitting opening OH.

The pixel defining film PDL may be of a polymer resin. For example, the pixel defining film PDL may be of a polyacrylate-based resin and/or a polyimide-based resin. In one or more embodiments, the pixel defining film PDL may be formed or provided by further including an inorganic material in addition to the polymer resin. In one or more embodiments, the pixel defining film PDL may be formed or provided by including a light-absorbing material, or may be formed or provided by including a black pigment and/or a black dye. The pixel defining film PDL formed or provided by including the black pigment and/or the black dye may implement a black pixel defining film. If (e.g., when) the pixel defining film PDL is formed or provided, carbon black, and/or the like may be used as a black pigment or a black dye, but embodiments of the present disclosure are not limited thereto.

In one or more embodiments, the pixel defining film PDL may be of an inorganic material. For example, the pixel defining film PDL may be of an inorganic material, such as silicon nitride (Si₃N₄), silicon oxide (SiOₓ, wherein 0 < x ≤ 2; e.g., SiO₂), or silicon oxynitride (SiON, Si₂ON₂, or SiₓO_{y}N_{z}, wherein 0 < x ≤ 4, 0 ≤ y ≤ 3, and 0 ≤ z ≤ 3).

The display layer DP-ED may include a first light-emitting region EA1, a second light-emitting region EA2, and a third light-emitting region EA3. The first light-emitting region EA1, the second light-emitting region EA2, and the third light-emitting region EA3 may be divided by the pixel defining film PDL. The first light-emitting region EA1, the second light-emitting region EA2, and the third light-emitting region EA3 may respectively correspond to the first pixel region PXA-R, the second pixel region PXA-G, and the third pixel region PXA-B. In one or more embodiments, the expression "one element corresponds to another element" refers to that two structures overlap each other if (e.g., when) viewed in the thickness direction DR3 of the display device DD and is not limited to a same area.

The light-emitting regions EA1, EA2, and EA3 may overlap the pixel regions PXA-R, PXA-G, and PXA-B and may not overlap the bank well region BWA. If (e.g., when) viewed on a plane (e.g., in a plan view), the areas of the pixel regions PXA-R, PXA-G, and PXA-B divided by the division pattern BMP may be larger than the areas of the light-emitting regions EA1, EA2, and EA3 divided by the pixel defining film PDL.

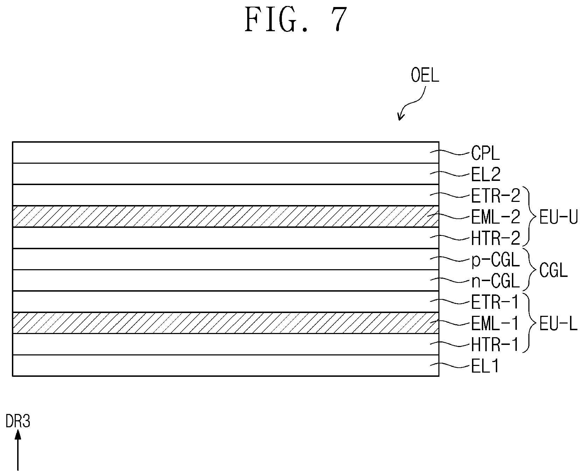

The light-emitting stack ST may be disposed or provided to overlap the pixel regions PXA-R, PXA-G, and PXA-B. In one or more embodiments, the light-emitting stack ST may be in the pixel regions PXA-R, PXA-G, and PXA-B. Each of a plurality of light-emitting structures EU-L and EU-U (see FIG. 7) included in the light-emitting stack ST may be disposed or provided throughout the pixel regions PXA-R, PXA-G, and PXA-B.

However, embodiments of the present disclosure are not limited thereto. At least one selected from among the plurality of light-emitting structures EU-L and EU-U (see FIG. 7) may be separately formed or provided in each of the first pixel region PXA-R, the second pixel region PXA-G, and the third pixel region PXA-B. In one or more embodiments, at least one selected from among the plurality of light-emitting structures EU-L and EU-U (see FIG. 7) may be patterned within the light-emitting opening OH and be separately formed or provided in each of the first pixel region PXA-R, the second pixel region PXA-G, and the third pixel region PXA-B.

The display layer DP-ED may include an encapsulation layer TFE that protects the light-emitting element OEL. The encapsulation layer TFE may include an organic material and/or an inorganic material. The encapsulation layer TFE may have a multi-layered structure in which inorganic/organic layers are repeated. In one or more embodiments, the encapsulation layer TFE may include a first inorganic layer IOL1, an organic layer OL, and a second inorganic layer IOL2 which are sequentially stacked. However, layers that constitute the encapsulation layer TFE are not limited thereto. The encapsulation layer TFE may be provided directly on the light-emitting element OEL in a continuous process.

The first inorganic layer IOL1 and the second inorganic layer IOL2 may protect the light-emitting element OEL from moisture and/or oxygen, and the organic layer OL may protect the light-emitting element OEL from foreign substances, such as dust particles. For example, the organic layer OL may prevent defects (or reduce a degree or occurrence of defects) in the light-emitting element OEL, which may be caused by being stabbed by foreign substances introduced during a manufacturing process. The display device DD may further include a refractive index control layer above the encapsulation layer TFE to improve or enhance light extraction efficiency.

The inorganic layers IOL1 and IOL2 may include at least one of silicon nitride, silicon oxynitride, silicon oxide, titanium oxide, or aluminium oxide. The organic layer OL may include an acrylate-based organic material. However, the types or kinds of materials that constitute the inorganic layers IOL1 and IOL2 and the organic layer OL are not limited thereto.

As illustrated in FIGS. 5 and 6A, the light control panel OSL may be on the encapsulation layer TFE. The light control panel OSL may include a light control layer CCL including quantum dots, and in one or more embodiments, the light control layer CCL may be on the encapsulation layer TFE. The light control panel OSL may further include a low refractive layer LR, a color filter layer CFL, and a base substrate BL in addition to the light control layer CCL.

The light control layer CCL may be on the display layer DP-ED including the light-emitting element OEL. The light control layer CCL may include a division pattern BMP and a plurality of light control units CCP-R, CCP-G, and CCP-B.

The division pattern BMP may be arranged or provided to divide the plurality of light control units CCP-R, CCP-G, and CCP-B from each other. The division pattern BMP may include a base resin and an additive. The base resin may be made of one or more suitable resin compositions, which may generally be referred to as a binder. The additive may include a coupling agent and/or a photoinitiator. The additive may further include a dispersant.

The division pattern BMP may include a black coloring agent for light blocking. The division pattern BMP may include a black dye and/or a black pigment mixed in the base resin. In one or more embodiments, the black coloring agent may include carbon black or may include a metal, such as chromium and/or an oxide thereof.

An opening BW-OH that corresponds to the light-emitting opening OH may be defined in the division pattern BMP. On a plane (e.g., in a plan view), the opening BW-OH may overlap the light-emitting opening OH and may have an area larger than that of the light-emitting opening OH. For example, the opening BW-OH may have a larger area than the light-emitting regions EA1, EA2, and EA3 defined by the light-emitting opening OH. The light control units CCP-R, CCP-G, and CCP-B may be inside the opening BW-OH.

In one or more embodiments, the light control layer CCL may include a first light control unit CCP-R that corresponds to the first pixel region PXA-R, a second light control unit CCP-G that corresponds to the second pixel region PXA-G, and a third light control unit CCP-B that corresponds to the third pixel region PXA-B. The first light control unit CCP-R may be a red light control unit that emits red light, and the second light control unit CCP-G may be a green light control unit that emits green light. The third light control unit CCP-B may be a blue light control unit that emits blue light. In one or more embodiments, the third light control unit CCP-B may be a transmission light control unit that transmits and emits source light. At least one selected from among the first light control unit CCP-R, the second light control unit CCP-G, and the third light control unit CCP-B of the light control layer CCL may include a quantum dot that converts the optical properties of source light.

In the light control panel OSL according to one or more embodiments of the present disclosure, the base substrate BL may be a member that provides a reference surface on which the color filter layer CFL, the low refractive layer LR, and the light control layer CCL are disposed or provided. The base substrate BL may be a glass substrate, a metal substrate, and/or a plastic substrate. However, embodiments of the present disclosure are not limited thereto, and the base substrate BL may be an inorganic layer, an organic layer, and/or a composite material layer. In one or more embodiments, unlike what is illustrated, the base substrate BL may not be provided.

In one or more embodiments, the light control layer CCL may include barrier layers CAP1 and CAP2. The barrier layers CAP1 and CAP2 may serve to prevent the penetration (or to reduce a degree or occurrence of the penetration) of moisture and/or oxygen (hereinafter referred to as 'moisture/oxygen') and improve or enhance the optical properties of the light control panel OSL by adjusting a refractive index. The barrier layers CAP1 and CAP2 may be on or below the light control layer CCL. The barrier layers CAP1 and CAP2 may be on one upper or lower side of the light control units CCP-R, CCP-G, and CCP-B and may block the light control units CCP-R, CCP-G, and CCP-B from being exposed to moisture/oxygen, and, for example, the barrier layers CAP1 and CAP2 may block quantum dots included in the light control units CCP-R, CCP-G, and CCP-B from being exposed to moisture/oxygen. The barrier layers CAP1 and CAP2 may also protect the light control units CCP-R, CCP-G, and CCP-B from an external impact.

In one or more embodiments, a first barrier layer CAP1 may be disposed or provided to be spaced and/or apart (e.g., spaced apart or separated) from the display layer DP-ED with the light control units CCP-R, CCP-G, and CCP-B therebetween. For example, the first barrier layer CAP1 may be on the upper surface of the light control units CCP-R, CCP-G, and CCP-B. In one or more embodiments, the light control layer CCL may further include a second barrier layer CAP2 between the light control units CCP-R, CCP-G, and CCP-B and the display layer DP-ED. In one or more embodiments, the first barrier layer CAP1 may cover the upper surfaces of the light control units CCP-R, CCP-G, and CCP-B adjacent to the low refractive layer LR, and the second barrier layer CAP2 may cover the lower surfaces of the light control units CCP-R, CCP-G, and CCP-B adjacent to the display layer DP-ED. In one or more embodiments, the "upper surface" may be a surface located at the top, based on the third direction DR3, and the "lower surface" may be a surface located at the bottom, based on the third direction DR3.

In one or more embodiments, the first barrier layer CAP1 and the second barrier layer CAP2 may cover one side of the division pattern BMP as well as the light control units CCP-R, CCP-G, and CCP-B.

The first barrier layer CAP1 and the second barrier layer CAP2 may be formed or provided by including an inorganic material. In one or more embodiments, the first barrier layer CAP1 may include silicon oxynitride (SiON). Both the first barrier layer CAP1 and the second barrier layer CAP2 may include silicon oxynitride. Without being limited thereto, however, the first barrier layer CAP1 may include silicon oxynitride, and the second barrier layer CAP2 may include silicon oxide (SiOₓ, wherein 0 < x ≤ 2; e.g., SiO₂).

The light control panel OSL may further include a color filter layer CFL on the light control layer CCL. The color filter layer CFL may include at least one selected from among color filters CF1, CF2, and CF3. The color filter may transmit light in a set or specific wavelength range and block light outside the wavelength range. In one or more embodiments, a first color filter CF1 may be a red filter that transmits red light, a second color filter CF2 may be a green filter that transmits green light, and a third color filter CF3 may be a blue filter that transmits blue light.

Each of the color filters CF1, CF2, and CF3 may include a polymer photosensitive resin and a colorant. The colorant may include a pigment and/or a dye. The first color filter CF1 may include a red pigment and/or a red dye, the second color filter CF2 may include a green pigment and/or a green dye, and the third color filter CF3 may include a blue pigment and/or a blue dye. In one or more embodiments, the third color filter CF3 may not include a pigment and/or a dye.

The first color filter CF1, the second color filter CF2, and the third color filter CF3 may be disposed or provided to respectively correspond to the first pixel region PXA-R, the second pixel region PXA-G, and the third pixel region PXA-B. In one or more embodiments, the first color filter CF1, the second color filter CF2, and the third color filter CF3 may be disposed or provided to respectively overlap the first light control unit CCP-R, the second light control unit CCP-G, and the third light control unit CCP-B.

In one or more embodiments, referring to FIG. 6A, the plurality of color filters CF1, CF2, and CF3 that transmit different light may be disposed or provided to overlap each other in response to the peripheral region NPXA. As the plurality of color filters CF1, CF2, and CF3 are disposed or provided to overlap each other in the third direction DR3, which is the thickness direction, in response to the peripheral region NPXA, it may demarcate the boundaries between adjacent pixel regions PXA-R, PXA-G, and PXA-B. In one or more embodiments, unlike what is illustrated, the color filter layer CFL may include a light blocking member that demarcates the boundaries between adjacent color filters CF1, CF2, and CF3. The light blocking member may be of a blue filter or may be formed or provided by including an organic light blocking material and/or an inorganic light blocking material, which may include a black pigment and/or a black dye.

Referring to FIGS. 5 and 6A, in one or more embodiments, the light control panel OSL may further include a low refractive layer LR. The low refractive layer LR may be between the light control layer CCL and the color filters CF1, CF2, and CF3. The low refractive layer LR may be between the light control units CCP-R, CCP-G, and CCP-B and the color filters CF1, CF2, and CF3 and perform a function as an optical functional layer, such as increasing or enhancing the light extraction efficiency of light emitted from the light control layer CCL or preventing reflected light from entering the light control layer CCL (or reducing a degree to or occurrence of which reflected light enters the light control layer CCL). The low refractive layer LR may be a layer having a relatively low refractive index compared to an adjacent layer.

The low refractive layer LR may include at least one inorganic layer. For example, the low refractive layer LR may be formed or provided by including silicon nitride, aluminium nitride, zirconium nitride, titanium nitride, hafnium nitride, tantalum nitride, silicon oxide, aluminium oxide, titanium oxide, tin oxide, cerium oxide, and/or silicon oxynitride, and/or a metal thin film having a secured light transmittance. However, embodiments of the present disclosure are not limited thereto, and the low refractive layer LR may include an organic film. For example, the low refractive layer LR may have a structure in which a plurality of hollow particles are dispersed in an organic polymer resin. The low refractive layer LR may be composed of a single layer or a plurality of layers.

In one or more embodiments, the display device DD may further include a base substrate BL on the color filter layer CFL. The base substrate BL may be a member that provides a reference surface on which the color filter layer CFL, the low refractive layer LR, and the light control layer CCL are disposed or provided. The base substrate BL may be a glass substrate, a metal substrate, or a plastic substrate. However, embodiments of the present disclosure are not limited thereto, and the base substrate BL may be an inorganic layer, an organic layer, or a composite material layer. Unlike what is illustrated, in one or more embodiments, the base substrate BL may not be provided.

An anti-reflection layer may be on the base substrate BL. The anti-reflection layer may reduce the reflectance of external light incident from the outside. The anti-reflection layer may selectively transmit light emitted from the display device DD. In one or more embodiments, the anti-reflection layer may be a single layer including a dye and/or a pigment dispersed in a base resin. The anti-reflection layer may be provided as one substantially continuous layer that completely overlaps all of the first pixel region PXA-R, the second pixel region PXA-G, and the third pixel region PXA-B.

The anti-reflection layer may not include a polarizing layer. In one or more embodiments, light that passes through the anti-reflection layer and incident toward the display layer DP-ED may not be polarized. The display layer DP-ED may receive unpolarized light from above the anti-reflection layer.

The display device DD according to one or more embodiments of the present disclosure may include a lower panel (e.g., display panel DP) including the display layer DP-ED and an upper panel (e.g., light control panel OSL) including the light control layer CCL and the color filter layer CFL, and in one or more embodiments, a filling layer FML may be between the lower panel and the upper panel. In one or more embodiments, the filling layer FML may fill a space between the display layer DP-ED and the light control panel OSL. The filling layer FML may be disposed or provided directly on the encapsulation layer TFE, and the second barrier layer CAP2 may be disposed or provided directly on the filling layer FML. The lower surface of the filling layer FML may be in contact with the upper surface of the encapsulation layer TFE, and the upper surface of the filling layer FML may be in contact with the lower surface of the second barrier layer CAP2.

The filling layer FML may function as a buffer between the display layer DP-ED of the lower panel and the light control layer CCL of the upper panel. In one or more embodiments, the filling layer FML may function as a shock absorber and increase or enhance the strength of the display device DD. The filling layer FML may be formed or provided from a filling resin including a polymer resin. For example, the filling layer FML may be formed or provided from a filling resin including an acrylate-based resin and/or an epoxy-based resin.

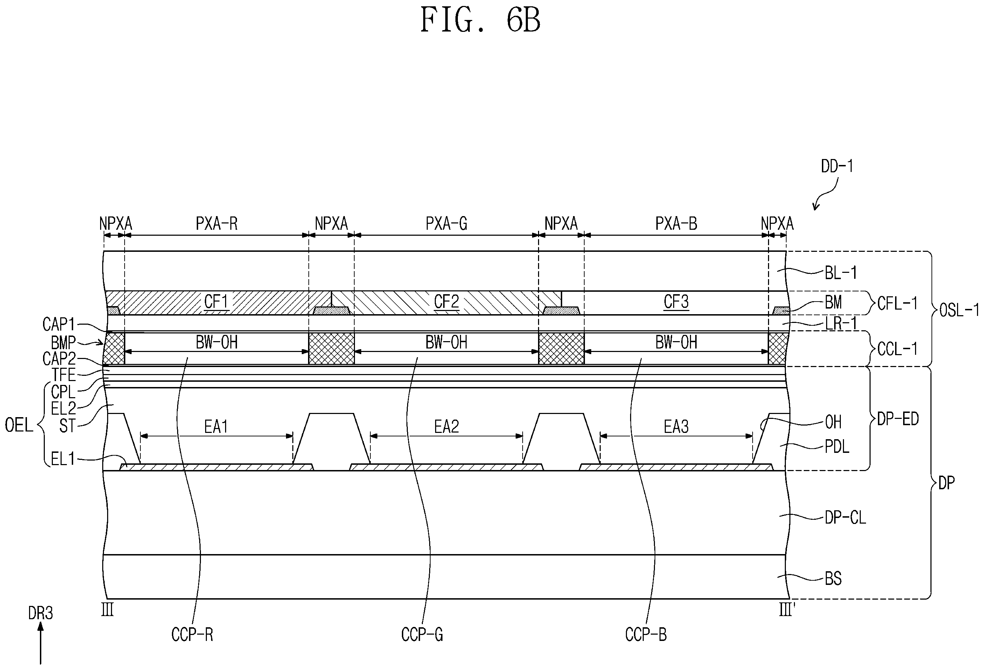

Each of FIGS. 6B-6C is a cross-sectional view illustrating a portion of a display device according to one or more embodiments of the present disclosure. Display devices according to one or more embodiments as illustrated in FIGS. 6B-6C may have one or more differences in the structure of the optical layer and/or the like compared to the display device according to one or more embodiments as described with reference to FIGS. 5 and 6A. Hereinafter, in the descriptions of the display devices according to one or more embodiments as described with reference to FIGS. 6B-6C, substantially the same contents as those described in FIGS. 1-6A will not be described again and differences will be mainly or predominantly illustrated.

Referring to FIG. 6B, a display device DD-1 according to one or more embodiments of the present disclosure may include a display panel DP including a base layer BS, a circuit layer DP-CL on the base layer BS, and a display layer DP-ED on the circuit layer DP-CL, and a light control panel OSL-1 on the display panel DP. In the display device DD-1 according to one or more embodiments of the present disclosure, the light control panel OSL-1 may include a light control layer CCL-1, a low refractive layer LR-1, a color filter layer CFL-1, and a base substrate BL-1 which are sequentially stacked on an encapsulation layer TFE. The light control panel OSL-1 may include a first barrier layer CAP1 and a second barrier layer CAP2 on the upper surface and the lower surface of the light control layer CCL-1.

Compared to the display device DD as illustrated in FIG. 6A, the display device DD-1 according to one or more embodiments of the present disclosure, which is illustrated in FIG. 6B, may be one embodiment in which the light control panel OSL-1 is disposed or provided on the upper surface of the encapsulation layer TFE as a base surface. For example, light control units CCP-R, CCP-G, and CCP-B of the light control layer CCL-1 may be formed or provided on the encapsulation layer TFE in a continuous process, and color filters CF1, CF2, and CF3 of the color filter layer CFL-1 may be sequentially formed or provided on the light control layer CCL-1 through a continuous process. Compared to one or more embodiments as illustrated in FIG. 6A, the filling layer FML (see FIG. 6A) may not be provided in the display device DD-1 according to one or more embodiments as illustrated in FIG. 6B.

In one or more embodiments, as illustrated in FIG. 6B, the light control layer CCL-1 may be formed or provided by using the upper surface of the second barrier layer CAP2 on the encapsulation layer TFE as a base surface so that the light control layer CCL-1 may have a shape that is vertically inverted from that of the light control layer CCL as illustrated in FIG. 6A. In one or more embodiments, the color filter layer CFL-1 may be formed or provided by using the upper surface of the light control layer CCL-1 as a base surface and may have a shape different from what is illustrated in FIG. 6A.

The color filter layer CFL-1 may include a plurality of color filters CF1, CF2, and CF3 and a light blocking member BM. In the color filter layer CFL-1 according to one or more embodiments of the present disclosure, the light blocking member BM may be a black matrix. The light blocking member BM may be formed or provided by including an organic light blocking material and/or an inorganic light blocking material including a black pigment and/or a black dye. The light blocking member BM may prevent light leakage (or reduce a degree or occurrence of light leakage) and demarcate boundaries between adjacent color filters CF1, CF2, and CF3.

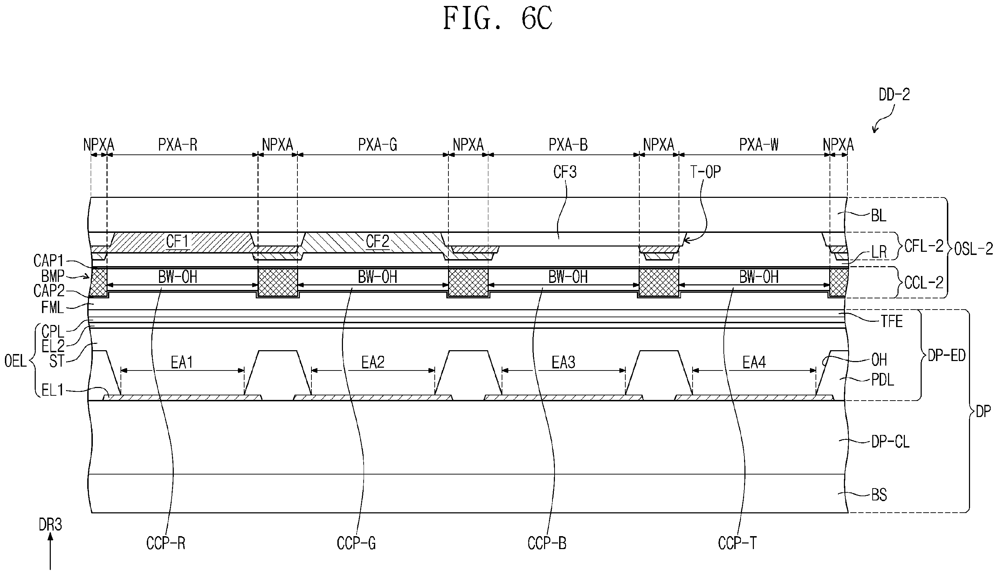

Compared to the display device DD as illustrated in FIG. 6A, a display device DD-2 according to one or more embodiments of the present disclosure, which is illustrated in FIG. 6C, may have a difference in that the display device DD-2 may further include a fourth pixel region PXA-W in addition to the first pixel region PXA-R, the second pixel region PXA-G, and the third pixel region PXA-B. The fourth pixel region PXA-W may be a white pixel region that emits white light.

In FIG. 6C, the widths on one side of the pixel regions PXA-R, PXA-G, PXA-B, and PXA-W are illustrated to be substantially the same as each other, but the fourth pixel region PXA-W may have a size different from that of each of other pixel regions PXA-R, PXA-G, and PXA-B. For example, the planar area of the fourth pixel region PXA-W may be different from the area of each of the first pixel region PXA-R, the second pixel region PXA-G, and the third pixel region PXA-B. White light emitted from the fourth pixel region PXA-W may be a mixture of light of one or more wavelengths. The display layer DP-ED may include a fourth light-emitting region EA4 that corresponds to the fourth pixel region PXA-W.

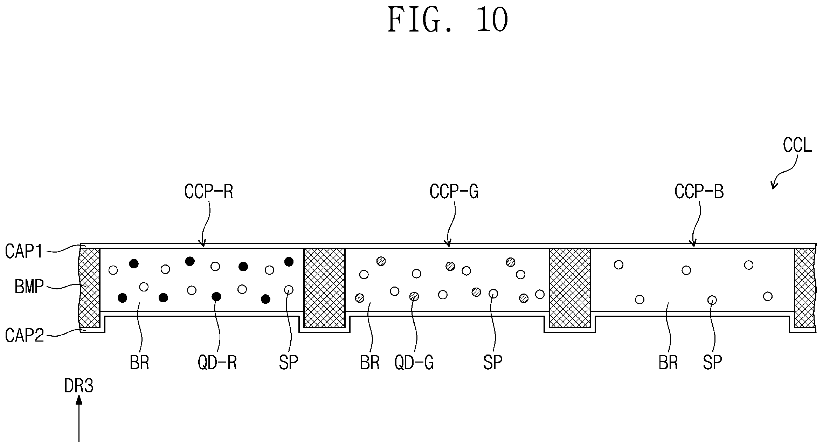

A light control layer CCL-2 of the display device DD-2 according to one or more embodiments of the present disclosure may further include a fourth light control unit CCP-T in addition to the first light control unit CCP-R, the second light control unit CCP-G, and the third light control unit CCP-B. The fourth light control unit CCP-T may be disposed or provided to overlap the fourth pixel region PXA-W. A division pattern BMP may be provided between the fourth light control unit CCP-T and another light control unit adjacent thereto. The fourth light control unit CCP-T may not include a light-emitting body, such as a quantum dot. The fourth light control unit CCP-T may be a transmission unit that transmits incident light without converting its wavelength. The fourth light control unit CCP-T may include a base resin and scatterers (e.g., light scatterers) dispersed within the base resin. Substantially the same contents as those described herein with reference to FIG. 10 and/or the like may be applied to the base resin and the scatterers.

An opening that overlaps the fourth pixel region PXA-W may be defined in a color filter layer CFL-2 of the display device DD-2 according to one or more embodiments of the present disclosure. At least a portion of the fourth pixel region PXA-W may not overlap both the light blocking member BM and the color filters CF1, CF2, and CF3 included in the color filter layer CFL-2. The light blocking member BM and the color filters CF1, CF2, and CF3 included in the color filter layer CFL-2 may not overlap the fourth light-emitting region EA4.

For example, in one or more embodiments, an opening T-OP that corresponds to the fourth pixel region PXA-W may be defined in the third color filter CF3 of the color filter layer CFL-2, and, in one or more embodiments, the light blocking member BM and the color filters CF1, CF2, and CF3 may not overlap the fourth pixel region PXA-W. Without being limited thereto, however, the third color filter CF3 may overlap the fourth pixel region PXA-W, and the third color filter CF3 may be of a transparent (e.g., substantially transparent) photosensitive resin.

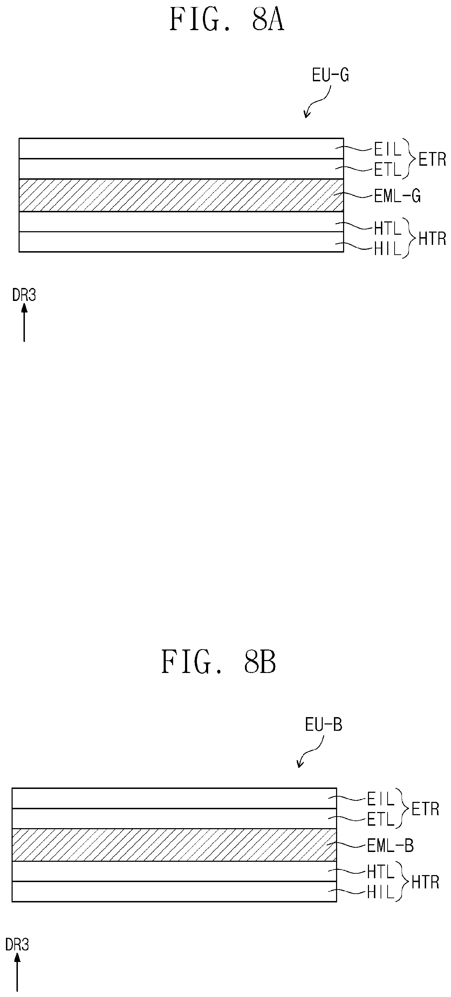

FIG. 7 is a cross-sectional view of a light-emitting element according to one or more embodiments of the present disclosure. Each of FIGS. 8A-8B illustrates a light-emitting structure included in the light-emitting element according to one or more embodiments of the present disclosure. FIG. 8A illustrates a light-emitting structure that emits green light among the light-emitting structures included in the light-emitting element according to one or more embodiments of the present disclosure, and FIG. 8B illustrates a light-emitting structure that emits blue light among the light-emitting structures included in the light-emitting element according to one or more embodiments of the present disclosure.

A green light-emitting structure EU-G according to one or more embodiments of the present disclosure as illustrated in FIG. 8A may emit green light having a central light-emitting wavelength of about 500 nm to about 590 nm. In one or more embodiments, as illustrated in FIG. 8B, a blue light-emitting structure EU-B may emit blue light having a central light-emitting wavelength of about 410 nm to about 480 nm.

The light-emitting element OEL according to one or more embodiments of the present disclosure may include a first electrode EL1, a second electrode EL2 facing (e.g., opposite to) the first electrode EL1, and a plurality of light-emitting structures EU-L and EU-U between the first electrode EL1 and the second electrode EL2. For example, the light-emitting element OEL according to one or more embodiments of the present disclosure may include two or more light-emitting structures between the first electrode EL1 and the second electrode EL2. The plurality of light-emitting structures EU-L and EU-U may respectively include light-emitting layers EML-1 and EML-2. For example, the plurality of light-emitting structures EU-L and EU-U may respectively include hole transport regions HTR-1 and HTR-2, light-emitting layers EML-1 and EML-2, and electron transport regions ETR-1 and ETR-2 stacked and disposed or provided between the first electrode EL1 and the second electrode EL2. The light-emitting element OEL according to one or more embodiments of the present disclosure may include a plurality of light-emitting layers stacked in the thickness direction and may be referred to as a tandem light-emitting element.

The light-emitting element OEL according to one or more embodiments of the present disclosure may include a charge generation layer CGL between the plurality of light-emitting structures EU-L and EU-U.

The stacked structure of the plurality of light-emitting structures EU-L and EU-U and the charge generation layer CGL between them may correspond to the light-emitting stack ST as illustrated in FIGS. 5-6C.

The light-emitting element OEL according to one or more embodiments of the present disclosure may include at least one blue light-emitting structure EU-B that emits blue light and at least one green light-emitting structure EU-G that emits green light. In the light-emitting element OEL according to one or more embodiments of the present disclosure as illustrated in FIG. 7, a lower light-emitting structure EU-L on the first electrode EL1 may be a blue light-emitting structure EU-B, and an upper light-emitting structure EU-U spaced and/or apart (e.g., spaced apart or separated) from the lower light-emitting structure EU-L with the charge generation layer CGL therebetween and disposed or provided above the lower light-emitting structure EU-L may be a green light-emitting structure EU-G. However, the arrangement characteristics of the light-emitting structures in the light-emitting element OEL are not limited to what is illustrated herein. Unlike what is illustrated in FIG. 7, the number of the blue light-emitting structures and the number of the green light-emitting structures included in the light-emitting element OEL may be changed, and the arrangement positions of the blue light-emitting structure and the green light-emitting structure may also be combined in one or more suitable ways.

In one or more embodiments, as illustrated in FIG. 7, light generated from the light-emitting element OEL may be emitted in the direction of the upper surface of the second electrode EL2, for example, in the third direction DR3. Source light generated from the light-emitting element OEL may include blue source light emitted from the blue light-emitting structure and green source light emitted from the green light-emitting structure and may be transmitted toward the light control layer CCL (see FIG. 6A). The blue source light may be referred to as light-emitting blue light, and the green source light may be referred to as light-emitting green light.

In one or more embodiments, if (e.g., when) a voltage is applied to the light-emitting element OEL, the charge generation layer CGL may generate charges (e.g., electrons and holes) by forming or providing a complex through an oxidation-reduction reaction. In one or more embodiments, the charge generation layer CGL may provide the generated charges to each of adjacent light-emitting structures EU-B and EU-G. The charge generation layer CGL may increase or enhance the efficiency of current generated in each of the adjacent light-emitting structures EU-B and EU-G and play a role in controlling the balance of the charges between the adjacent light-emitting structures EU-B and EU-G.

The charge generation layer CGL may have a layer structure in which a negative type (n-type) charge generation layer n-CGL and a positive type (p-type) charge generation layer p-CGL are bonded to each other.

The n-type charge generation layer n-CGL may provide electrons to adjacent light-emitting structures EU-B and EU-G. The n-type charge generation layer n-CGL may be a layer in which a base material is doped with an n-dopant. The p-type charge generation layer p-CGL may provide holes to adjacent light-emitting structures EU-B and EU-G. The p-type charge generation layer p-CGL may be a layer in which a base material is doped with a p-dopant.

A buffer layer may be further disposed or provided between the n-type charge generation layer n-CGL and the p-type charge generation layer p-CGL.

The charge generation layer CGL may include an n-type arylamine-based material or a p-type metal oxide. For example, the charge generation layer CGL may include a charge generating compound composed of an arylamine-based organic compound, a metal, a metal oxide, a metal carbide, a metal fluoride, or a mixture thereof.

For example, the arylamine-based organic compound may include α-NPD, 2-TNATA, TDATA, MTDATA, spiro-TAD, and/or spiro-NPB. For example, the metal may be cesium (Cs), molybdenum (Mo), vanadium (V), titanium (Ti), tungsten (W), barium (Ba), and/or lithium (Li). In one or more embodiments, for example, the metal oxide, the metal carbide, and the metal fluoride may be Re₂O₇, MoO₃, V₂O₅, WO₃, TiO₂, Cs₂CO₃, BaF₂, LiF, and/or CsF.

In the light-emitting element OEL according to one or more embodiments of the present disclosure, the first electrode EL1 may be a reflective electrode. For example, the first electrode EL1 may include silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), LiF/Ca, LiF/Al, molybdenum (Mo), titanium (Ti), tungsten (W), indium (In), zinc (Zn), tin (Sn), or a compound or mixture thereof (for example, a mixture of Ag and Mg), which exhibits or provide a relatively high reflectance. In one or more embodiments, the first electrode EL1 may have a multi-layered structure including: a reflective film of the foregoing materials; and a transparent (e.g., substantially transparent) conductive (e.g., electrically conductive) film of indium tin oxide (ITO), indium zinc oxide (IZO), zinc oxide (ZnO), indium tin zinc oxide (ITZO), and/or the like. For example, the first electrode EL1 may have a two-layer structure of ITO/Ag and a three-layer structure of ITO/Ag/ITO, but embodiments of the present disclosure are not limited thereto. In one or more embodiments, without being limited thereto, the first electrode EL1 may include a metal material as described in one or more embodiments, a combination of two or more metal materials selected from among the metal materials as described in one or more embodiments, oxides of the metal materials as described in one or more embodiments, and/or the like.

In the light-emitting element OEL according to one or more embodiments of the present disclosure, the second electrode EL2 may be a semi-transmissive electrode or a transmissive electrode. If (e.g., when) the second electrode EL2 is a transmissive electrode, the second electrode EL2 may be of a transparent metal oxide, such as indium tin oxide (ITO), indium zinc oxide (IZO), zinc oxide (ZnO), and indium tin zinc oxide (ITZO).

If (e.g., when) the second electrode EL2 is a semi-transmissive electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, In, Zn, Sn, or a compound or mixture including them (e.g., AgMg, AgYb, or MgAg). In one or more embodiments, the second electrode EL2 may have a multi-layered structure including a reflective or semi-transmissive film of the foregoing materials and a transparent (e.g., substantially transparent) conductive (e.g., electrically conductive) film of indium tin oxide (ITO), indium zinc oxide (IZO), zinc oxide (ZnO), indium tin zinc oxide (ITZO), and/or the like. For example, the second electrode EL2 may include a metal material as described in one or more embodiments, a combination of two or more metal materials selected from among the foregoing metal materials, oxides of the foregoing metal materials, and/or the like.

In the light-emitting element OEL according to one or more embodiments of the present disclosure, the light-emitting structures EU-L and EU-U may respectively include hole transport regions HTR-1 and HTR-2. Each of the hole transport regions HTR-1 and HTR-2 may include a hole transport material that is generally available or generally used. The hole transport regions HTR-1 and HTR-2 may be formed or provided by using one or more suitable methods, such as a vacuum deposition method, a spin coating method, a casting method, a Langmuir-Blodgett (LB) method, an inkjet printing method, a laser printing method, and/or a laser induced thermal imaging (LITI) method.

The hole transport regions HTR-1 and HTR-2 may have a single layer of a single material, a single layer of a plurality of different materials, or a multi-layered structure having a plurality of layers of a plurality of different materials.

Referring to FIGS. 8A-8B, the hole transport region HTR may include a hole injection layer HIL and a hole transport layer HTL. In one or more embodiments, the hole transport region HTR may include at least one of a hole injection layer HIL, a hole transport layer HTL, a buffer layer or a light-emitting auxiliary layer, or an electron blocking layer. In one or more embodiments, the hole transport region HTR may have a single-layered structure of a plurality of different materials or may have a structure of a hole injection layer HIL/a hole transport layer HTL, a hole injection layer HIL/a hole transport layer HTL/a buffer layer, a hole injection layer HIL/a buffer layer, or a hole transport layer HTL/a buffer layer, which are sequentially stacked, but embodiments of the present disclosure are not limited thereto.

In the light-emitting element OEL according to one or more embodiments of the present disclosure as illustrated in FIG. 7, the light-emitting layers EML-1 and EML-2 may be respectively on the hole transport regions HTR-1 and HTR-2. For example, each of the light-emitting layers EML-1 and EML-2 may have a thickness of about 100 Å to about 1000 Å or about 100 Å to about 300 Å.

In the light-emitting element OEL according to one or more embodiments of the present disclosure as illustrated in FIG. 7, a first light-emitting layer EML-1 in the lower portion thereof and a second light-emitting layer EML-2 in the upper portion thereof may emit light in different wavelength ranges. The light-emitting element OEL may provide the light control layer CCL (see FIG. 6A) with source light including a first light-emitting color light emitted from the first light-emitting layer EML-1 and a second light-emitting color light emitted from the second light-emitting layer EML-2. For example, in one or more embodiments, the first light-emitting color light may be blue light, and the second light-emitting color light may be green light. For example, in the light-emitting element OEL according to one or more embodiments of the present disclosure, the first light-emitting layer EML-1 may be a blue light-emitting layer EML-B, and the second light-emitting layer EML-2 may be a green light-emitting layer EML-G.

Each of the light-emitting layers EML-1 and EML-2 may have a single layer of a single material, a single layer of a plurality of different materials, or a multi-layered structure having a plurality of layers of a plurality of different materials. The light-emitting layers EML-1 and EML-2 may include a fluorescent light-emitting material or a phosphorescent light-emitting material. The light-emitting layers EML-1 and EML-2 may include a host material. In one or more embodiments, at least one selected from among the light-emitting layers EML-1 and EML-2 may include both (e.g., simultaneously) a hole transporting host and an electron transporting host.

In the light-emitting element OEL according to one or more embodiments of the present disclosure, the light-emitting layers EML-1 and EML-2 may include an anthracene derivative, a pyrene derivative, a fluoranthene derivative, a chrysene derivative, a dihydrobenzanthracene derivative, a triphenylene derivative, and/or the like. For example, the light-emitting layers EML-1 and EML-2 may include an anthracene derivative, a pyrene derivative, and/or the like. However, embodiments of the present disclosure are not limited thereto, and the light-emitting layers EML-1 and EML-2 may include a light-emitting material that is generally available or generally used.

The light-emitting structures EU-L and EU-U of the light-emitting element OEL according to one or more embodiments of the present disclosure may respectively include electron transport regions ETR-1 and ETR-2. Each of the electron transport regions ETR-1 and ETR-2 may include an electron transport material that is generally available or generally used. Each of the electron transport regions ETR-1 and ETR-2 may be formed or provided by using one or more suitable methods, such as a vacuum deposition method, a spin coating method, a casting method, a Langmuir-Blodgett (LB) method, an inkjet printing method, a laser printing method, and/or a laser induced thermal imaging (LITI) method.

The electron transport regions ETR-1 and ETR-2 included in the light-emitting structures EU-L and EU-U may have a single layer of a single material, a single layer of a plurality of different materials, or a multi-layered structure having a plurality of layers of a plurality of different materials.

Referring to FIGS. 8A-8B, the electron transport region ETR may include an electron transport layer ETL and an electron injection layer EIL. In one or more embodiments, the electron transport region ETR may include at least one of an electron injection layer EIL, an electron transport layer ETL, or a hole blocking layer. In one or more embodiments, the electron transport region ETR may have a structure of an electron transport layer ETL/an electron injection layer EIL, a hole blocking layer/an electron transport layer ETL/an electron injection layer EIL, an electron transport layer ETL/a buffer layer/an electron injection layer EIL, and/or the like, which are stacked, but embodiments of the present disclosure are not limited thereto. In one or more embodiments, at least one selected from among the electron injection layer EIL, the electron transport layer ETL, and the hole blocking layer may include the materials of the electron transport region as described in one or more embodiments.

In one or more embodiments, a capping layer CPL may be further on the second electrode EL2 of the light-emitting element OEL according to one or more embodiments of the present disclosure. The capping layer CPL may include a plurality of layers or a single layer.

In one or more embodiments, the capping layer CPL may be an organic layer and/or an inorganic layer. For example, if (e.g., when) the capping layer CPL includes an inorganic material, the inorganic material may include an alkali metal compound, such as LiF, an alkaline earth metal compound, such as MgF₂, SiON, SiN_{X}, SiO_{y}, and/or the like.

For example, if (e.g., when) the capping layer CPL includes an organic material, the organic material may include α-NPD, NPB, TPD, m-MTDATA, Alq₃, CuPc, TPD15 (N4,N4,N4',N4'-tetra (biphenyl-4-yl) biphenyl-4,4'-diamine), TCTA (4,4',4"-Tris (carbazol-9-yl)-triphenylamine), and/or the like, and/or include an epoxy resin and/or an acrylate resin, such as a methacrylate resin. However, embodiments of the present disclosure are not limited thereto, and the capping layer CPL may include at least one selected from among the following compounds P1 to P5.

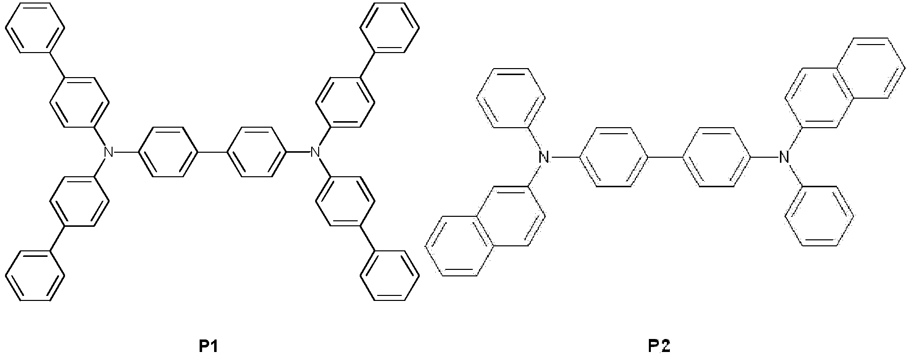

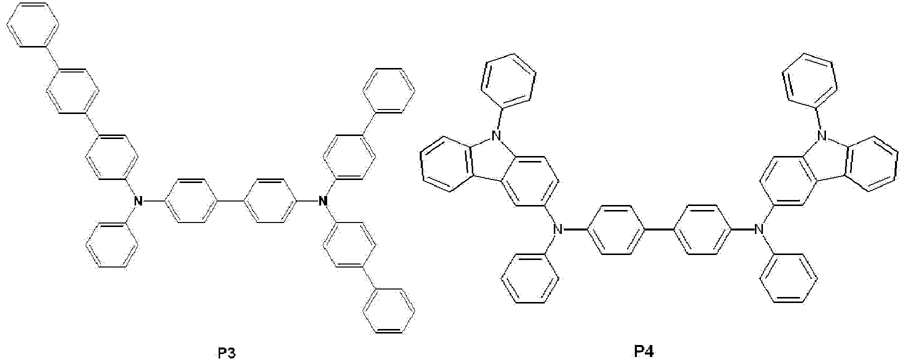

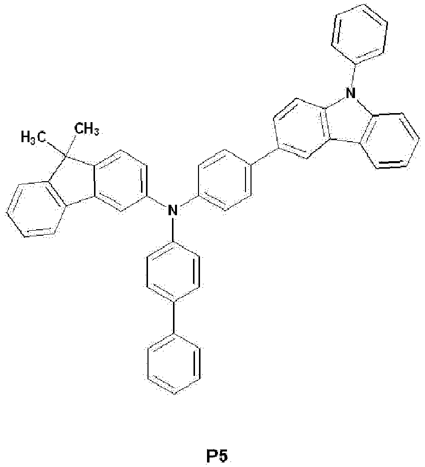

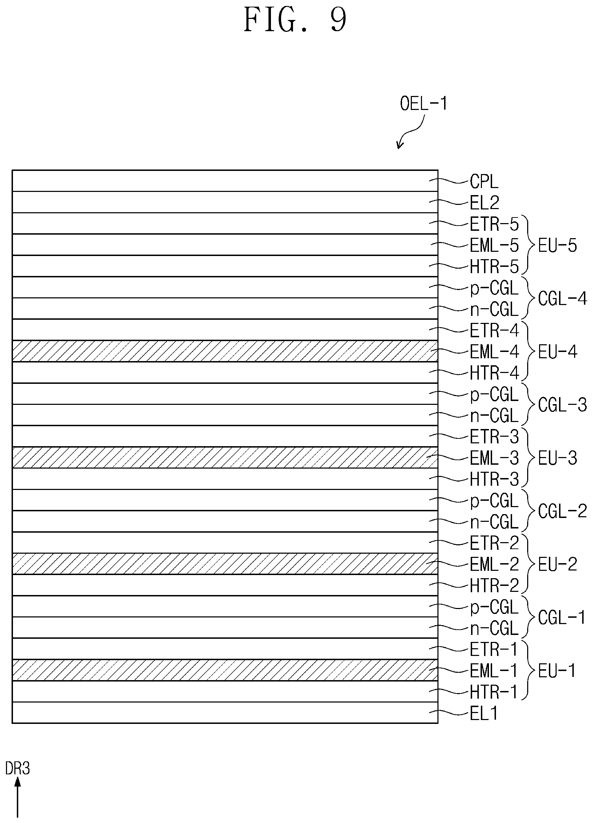

FIG. 9 illustrates a light-emitting element according to one or more embodiments of the present disclosure. Compared to the light-emitting element OEL according to one or more embodiments as illustrated in FIG. 7, a light-emitting element OEL-1 according to one or more embodiments of the present disclosure as illustrated in FIG. 9 may have a difference in that the number of the light-emitting structures between the first electrode EL1 and the second electrode EL2 is greater. Substantially the same contents as those described with reference to FIGS. 7-8B may be applied to the configuration or arrangement of the light-emitting structures and the configuration or arrangement of the charge generation layer included in the light-emitting element OEL-1 of FIG. 9.

The light-emitting element OEL-1 according to one or more embodiments of the present disclosure may include a first electrode EL1, a second electrode EL2 facing (e.g., opposite to) the first electrode EL1, a first light-emitting structure EU-1, a second light-emitting structure EU-2, a third light-emitting structure EU-3, a fourth light-emitting structure EU-4, and a fifth light-emitting structure EU-5, and a first charge generation layer CGL-1, a second charge generation layer CGL-2, a third charge generation layer CGL-3, and a fourth charge generation layer CGL-4, which are between the first electrode EL1 and the second electrode EL2.

The first charge generation layer CGL-1 may be between the first light-emitting structure EU-1 and the second light-emitting structure EU-2, the second charge generation layer CGL-2 may be between the second light-emitting structure EU-2 and the third light-emitting structure EU-3, the third charge generating layer CGL-3 may be between the third light-emitting structure EU-3 and the fourth light-emitting structure EU-4, and the fourth charge generation layer CGL-4 may be between the fourth light-emitting structure EU-4 and the fifth light-emitting structure EU-5. Each of the first charge generation layer CGL-1, the second charge generation layer CGL-2, the third charge generation layer CGL-3, and the fourth charge generation layer CGL-4 may include an n-type charge generation layer n-CGL and a p-type charge generation layer p-CGL. The light-emitting element OEL-1 may include a capping layer CPL on the second electrode EL2. The contents of the charge generation layer CGL as described with reference to FIG. 7, and/or the like may be substantially equally applied to the first charge generation layer CGL-1, the second charge generation layer CGL-2, the third charge generation layer CGL-3, and the fourth charge generation layer CGL-4.

The first light-emitting structure EU-1, the second light-emitting structure EU-2, the third light-emitting structure EU-3, the fourth light-emitting structure EU-4, and the fifth light-emitting structure EU-5 may respectively include the stacked structures of hole transport region HTR-1, HTR-2, HTR-3, HTR-4, and HTR-5, light-emitting layers EML-1, EML-2, EML-3, EML-4, and EML-5, and electron transport regions ETR-1, ETR-2, ETR-3, ETR-4, and ETR-5. The descriptions of the hole transport regions, the light-emitting layers, and the electron transport regions provided with reference to FIGS. 7-8B may be substantially equally applied to the hole transport regions HTR-1, HTR-2, HTR-3, HTR-4, and HTR-5, the light-emitting layers EML-1, EML-2, EML-3, EML-4, and EML-5, and the electron transport regions ETR-1, ETR-2, ETR-3, ETR-4, and ETR-5.

At least one selected from among the plurality of light-emitting structures EU-1, EU-2, EU-3, EU-4, and EU-5 of the light-emitting element OEL-1 according to one or more embodiments of the present disclosure may be a green light-emitting structure EU-G (see FIG. 8A), and the remaining light-emitting structures may be blue light-emitting structures EU-B (see FIG. 8B). For example, two of the plurality of light-emitting structures EU-1, EU-2, EU-3, EU-4, and EU-5 of the light-emitting element OEL-1 according to one or more embodiments of the present disclosure may be green light-emitting structures EU-G (see FIG. 8A), and the remaining light-emitting structures may be blue light-emitting structures EU-B (see FIG. 8B).

For example, in one or more embodiments, in the structure of the light-emitting element OEL-1 that emits light in the direction of the upper surface of the second electrode EL2, each of the third light-emitting structure EU-3 and the fifth light-emitting structure EU-5 may be a green light-emitting structure EU-G (see FIG. 8A). In one or more embodiments, each of the first light-emitting structure EU-1, the second light-emitting structure EU-2, and the fourth light-emitting structure EU-4 may correspond to a blue light-emitting structure EU-B as described with reference to FIG. 8B.

However, embodiments of the present disclosure are not limited thereto, and if (e.g., when) at least one selected from among the plurality of light-emitting structures EU-1, EU-2, EU-3, EU-4, and EU-5 is a green light-emitting structure and at least one selected from among the remaining light-emitting structures is a blue light-emitting structure, the number and stacking order of the green light-emitting structures and the blue light-emitting structures included in the light-emitting element OEL-1 may be changed depending on the characteristics of source light as desired or required for the display panel DP (see FIG. 2).

The light-emitting elements OEL and OEL-1 according to one or more embodiments of the present disclosure as illustrated in FIGS. 7 and 9 may be included in the display layers DP-ED of the display devices DD, DD-1, and DD-2 according to one or more embodiments of the present disclosure as illustrated in FIGS. 6A-6C. The display layers DP-ED including the light-emitting elements OEL and OEL-1 according to one or more embodiments of the present disclosure may include light-emitting green light and light-emitting blue light as source light, and the source light may be transmitted to the light control layers CCL, CCL-1, and CCL-2.

FIG. 10 is a cross-sectional view of a light control layer according to one or more embodiments of the present disclosure. The light control layer CCL may include a first light control unit CCP-R, a second light control unit CCP-G, and a third light control unit CCP-B that are divided from each other on a plane (e.g., in a plan view). The light control layer CCL according to one or more embodiments of the present disclosure as illustrated in FIG. 10 may be included in the configuration or arrangement of the light control panels OSL, OSL-1, and OSL-2 of the display devices DD, DD-1, and DD-2 as described with reference to FIGS. 6A-6C. The light control layer CCL according to one or more embodiments of the present disclosure may further include a division pattern BMP that divides the light control units CCP-R, CCP-G, and CCP-B into each other and barrier layers CAP1 and CAP2 that protect the light control units CCP-R, CCP-G, and CCP-B.

In one or more embodiments, quantum dots may be included in at least one selected from among the light control units CCP-R, CCP-G, and CCP-B of the light control layer CCL.

In the present disclosure, a "quantum dot" refers to a crystal of a semiconductor compound. The quantum dot may emit light of one or more light-emitting wavelengths depending on the size of the crystal. The quantum dot may emit light of one or more light-emitting wavelengths by adjusting the element ratio of the semiconductor compound.

The average diameter of the quantum dot may be, for example, about 1 nm or more (e.g., about 1 nm to about 10 nm), or about 3 nm or more (e.g., about 3 nm to about 10 nm). The quantum dot may be synthesized by a wet chemical process, a metal organic chemical vapor deposition process, a molecular beam epitaxy process, or a process substantially similar thereto. The average diameter of the quantum dot may be measured, for example, by a particle size analyzer, by a transmission electron microscope image, or by a scanning electron microscope image. Alternatively, it is possible to obtain an average particle diameter value by measuring using a dynamic light scattering method, performing data analysis, counting the number of particles for each particle size range, and calculating the average particle diameter. Unless otherwise defined, the average particle diameter may mean the diameter (D₅₀) of particles having a cumulative volume of 50 volume% in the particle size distribution.

Among the quantum dot manufacturing processes, the wet chemical process is a method of mixing an organic solvent and a precursor material to each other and then growing a quantum dot particle crystal. If (e.g., when) the quantum dot particle crystal grows, the organic solvent may naturally act as a dispersant coordinated on the surface of the quantum dot crystal and control the growth of the particle crystal. In one or more embodiments, the wet chemical process may be easier than a vapor deposition method, such as a metal organic chemical vapor deposition (MOCVD) process or a molecular beam epitaxy (MBE) process, and the growth of quantum dot particles may be controllable through a low-cost process.

The core of the quantum dot may be selected from among a group II-VI compound, a group III-V compound, a group III-VI compound, a group I-III-VI compound, a group IV-VI compound, a group IV element, a group IV compound, and combinations thereof.

The group II-VI compound may be selected from the group consisting of: a binary compound selected from the group consisting of CdSe, CdTe, CdS, ZnS, ZnSe, ZnTe, ZnO, HgS, HgSe, HgTe, MgSe, MgS, and mixtures thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and mixtures thereof. In one or more embodiments, the group II-VI semiconductor compound may further include a group I metal and/or a group IV element. A group I-II-VI compound may be selected from CuSnS or CuZnS, and a Group II-IV-VI compound may be selected from ZnSnS and/or the like. A group I-II-IV-VI compound may be selected from among quaternary compounds that are selected from the group consisting of Cu₂ZnSnS₂, Cu₂ZnSnS₄, Cu₂ZnSnSe₄, Ag₂ZnSnS₂, and mixtures thereof.

The group III-VI compound may include a binary compound, such as In₂S₃ and In₂Se₃, a ternary compound, such as InGaS₃ and InGaSe₃, or any combinations thereof.

The group I-III-VI compound may be selected from a ternary compound selected from the group consisting of AgInS, AgInS₂, CuInS, CuInS₂, AgGaS₂, CuGaS₂ CuGaO₂, AgGaO₂, AgAlO₂, and mixtures thereof, or a quaternary compound, such as AgInGaS₂, and CuInGaS₂.

The group III-V compound may be selected from the group consisting of: a binary compound selected from the group consisting of GaN, GaP, GaAs, GaSb, AlN, AlP, AlAs, AlSb, InN, InP, InAs, InSb, and mixtures thereof; a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and mixtures thereof; and a quaternary compound selected from the group consisting of GaAlNP, GaAlNAs, GaAINSb, GaAlPAs, GaAlPSb, GaInNP, GaInNAs, GaInNSb, GaInPAs, GaInPSb, InAlNP, InAINAs, InAlNSb, InAlPAs, InAlPSb, and mixtures thereof. In one or more embodiments, the group III-V compound may further include a group II metal. For example, InZnP and/or the like may be selected as a group III-II-V compound.

The group IV-VI compound may be selected from the group consisting of: a binary compound selected from the group consisting of SnS, SnSe, SnTe, PbS, PbSe, PbTe, and mixtures thereof; a ternary compound selected from the group consisting of SnSeS, SnSeTe, SnSTe, PbSeS, PbSeTe, PbSTe, SnPbS, SnPbSe, SnPbTe, and mixtures thereof; and a quaternary compound selected from the group consisting of SnPbSSe, SnPbSeTe, SnPbSTe, and mixtures thereof.

An example of a group II-IV-V semiconductor compound may be a ternary compound selected from the group consisting of ZnSnP, ZnSnP₂, ZnSnAs₂, ZnGeP₂, ZnGeAs₂, CdSnP₂, CdGeP₂, and mixtures thereof.

The group IV element may be selected from the group consisting of Si, Ge, and mixtures thereof. The group IV compound may be a binary compound selected from the group consisting of SiC, SiGe, and mixtures thereof.

Each element included in a multi-element compound, such as a binary compound, a ternary compound, and a quaternary compound, may be present in a particle at a uniform (e.g., substantially uniform) or non-uniform (e.g., substantially non-uniform) concentration. For example, a chemical formula representing quantum dots indicates the types or kinds of elements included in a quantum dot compound, and the ratio of elements in the compound may be different.

In one or more embodiments, the binary compound, the ternary compound, or the quaternary compound may be present in a particle at a uniform (e.g., substantially uniform) concentration, or they may be present in a same particle by being divided into states in which the concentration distributions thereof are partially different from one another. In one or more embodiments, the quantum dots may have a core/shell structure in which one quantum dot surrounds (e.g., is around) another quantum dot. The core/shell structure may have a concentration gradient in which the concentration of an element present in the shell gradually decreases toward the core.

In one or more embodiments, the quantum dots may have a core-shell structure including: a core including a nanocrystal as described in one or more embodiments; and a shell surrounding (e.g., around) the core. The shell of the quantum dots may serve as a protective layer to maintain semiconductor characteristics by preventing the chemical modification (or by reducing a degree or occurrence of the chemical modification) of the core and/or as a charging layer to impart electrophoretic characteristics to the quantum dots. The shell may be single-layered or multi-layered. An example of the shell of the quantum dots may include a metal oxide, a non-metal oxide, a semiconductor compound, or a combination thereof.

For example, the metal oxide or the non-metal oxide may include a binary compound, such as SiO₂, Al2O₃, TiO₂, ZnO, MnO, Mn₂O₃, Mn₃O₄, CuO, FeO, Fe₂O₃, Fe₃O₄, CoO, Co₃O₄, and NiO, or a ternary compound, such as MgAl₂O₄, CoFe₂O₄, NiFe₂O₄, and CoMn₂O₄, but embodiments of the present disclosure are not limited thereto.

In one or more embodiments, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

For example, if (e.g., when) the quantum dots of the group III-V compound have a core-shell structure, the core may include InP or InZnP, and the shell may include ZnSeS or may have a double shell structure of ZnSe/ZnS. However, embodiments of the present disclosure are not limited thereto, and the quantum dots may have a combination of a core and a shell selected from the semiconductor compounds as described in one or more embodiments.

The quantum dot may have a full width of half maximum (FWHM) of a light-emitting wavelength spectrum of about 45 nm or less, for example, about 40 nm or less, or, for example, about 30 nm or less, and within the foregoing ranges, color purity and/or color reproducibility may be improved or enhanced. In one or more embodiments, because light emitted through the quantum dot is emitted in all directions, a wide viewing angle may be improved or enhanced.

In one or more embodiments, the shape of the quantum dot is not limited to those generally used in the art, but, for example, a shape, such as a spherical (e.g., substantially spherical), pyramidal (e.g., substantially pyramidal), multi-armed (e.g., substantially multi-armed), or cubic (e.g., substantially cubic) nanoparticle, nanotube, nanowire, nanofiber, and nanoplate particle may be used.

Because an energy band gap may be controlled by adjusting the size of the quantum dot or the ratio of elements in a quantum dot compound, light of one or more wavelengths may be obtained from a quantum dot light-emitting layer. In one or more embodiments, by using the quantum dot as described in one or more embodiments (e.g., by using quantum dots of different sizes or different element ratios in the quantum dot compound), a light-emitting element configured or provided to emit light of one or more wavelengths may be implemented. For example, the control of the size of the quantum dot or the ratio of elements in the quantum dot compound may be selected so as to emit red light, green light, and/or blue light. In one or more embodiments, the quantum dots may be configured or provided to emit white light by combining light of one or more colors.

In one or more embodiments, if (e.g., when) the particle size of a quantum dot is smaller, light of a shorter wavelength range may be emitted. For example, among quantum dots having a substantially same core, the quantum dots that emit green color light may have a smaller particle size than the quantum dots that emit red color light. In one or more embodiments, among quantum dots having a substantially same core, the quantum dots that emit blue color light may have a smaller particle size than the quantum dots that emit green color light. However, embodiments of the present disclosure are not limited thereto, and even among quantum dots having a substantially same core, the particle sizes thereof may be adjusted according to a shell-forming material, a shell thickness, and/or the like.

In one or more embodiments, if (e.g., when) the quantum dots have one or more light-emitting colors, such as a blue color, a red color, or a green color, the quantum dots having different light-emitting colors may have different core materials.

The first light control unit CCP-R may correspond to the first pixel region (e.g., a red light-emitting region PXA-R) (see FIG. 6A), the second light control unit CCP-G may correspond to the second pixel region (e.g., a green light-emitting region PXA-G) (see FIG. 6A), and the third light control unit CCP-B may correspond to the third pixel region (e.g., a blue light-emitting region PXA-B) (see FIG. 6A).

In one or more embodiments, the first light control unit CCP-R may be referred to as a red light control unit, the second light control unit CCP-G may be referred to as a green light control unit, and the third light control unit CCP-B may be referred to as a blue light control unit.

In one or more embodiments, the first light control unit CCP-R may include first quantum dots QD-R, and the second light control unit CCP-G may include second quantum dots QD-G. The first light control unit CCP-R, the second light control unit CCP-G, and the third light control unit CCP-B may include a base resin portion BR. In one or more embodiments, each of the first light control unit CCP-R, the second light control unit CCP-G, and the third light control unit CCP-B may further include scatterers SP (e.g., light scatterers SP). The first quantum dots QD-R and the scatterers SP may be dispersedly disposed or provided in the base resin portion BR in the first light control unit CCP-R, and the second quantum dots QD-G and the scatterers SP may be dispersedly disposed or provided in the base resin portion BR in the second light control unit CCP-G. In one or more embodiments, the scatterers SP may be dispersedly disposed or provided in the base resin portion BR in the third light control unit CCP-B.

In one or more embodiments, the third light control unit CCP-B may not include quantum dots. However, embodiments of the present disclosure are not limited thereto, and the third light control unit CCP-B may further include quantum dots which are converted into light having a wavelength range different from those of the first light control unit and the second light control unit.

In one or more embodiments, the scatterers SP may make light incident to the light control units CCP-R, CCP-G, and CCP-B be scattered and emitted uniformly (e.g., substantially uniformly). The scatterers SP may scatter and emit source light or scatter and emit light whose wavelength has been converted from the source light.

The scatterers SP may have a spherical (e.g., substantially spherical) shape with a diameter of tens to hundreds of nanometers. For example, in one or more embodiments, the diameter of the scatterers SP may be about 50 nm to about 300 nm. For example, in one or more embodiments, the diameter of the scatterers SP may be about 200 nm. The diameter of the scatterers SP may be an average particle diameter. The average particle diameter of the scatterers SP may be determined by methods to measure average particle diameter as described herein.

The scatterers SP may include an inorganic particle. For example, the scatterers SP may include TiO₂, BaTiO₃, ZnO, ZnS, Al₂O₃, SiO₂, and/or hollow silica.

The base resin portion BR may be a medium in which the quantum dots QD-R and QD-G and the scatterers SP are dispersed and may be of one or more suitable compositions that may generally be referred to as binders. For example, the base resin portion BR may be an acrylate-based resin portion, a urethane-based resin portion, a silicone-based resin portion, and/or an epoxy-based resin portion. The base resin portions BR included in the first light control unit CCP-R, the second light control unit CCP-G, and the third light control unit CCP-B may be substantially the same as each other, or a base resin portion in at least one light control unit may be different from a base resin portion in the remaining light control units.

In one or more embodiments, the first quantum dot QD-R may be a red quantum dot, and the second quantum dot QD-G may be a green quantum dot.

In one or more embodiments, the first light control unit CCP-R may include In and P as the first quantum dot QD-R. For example, the first quantum dot QD-R may be InP. However, embodiments of the present disclosure are not limited thereto, and the first quantum dot QD-R may be used without limitation if (e.g., when) the first quantum dot QD-R is a quantum dot that receives source light including light-emitting green light and light-emitting blue light provided from the display layer and converts the wavelength of the source light into red light.

In one or more embodiments, the second light control unit CCP-G may include a multi-component quantum dot including Ag, In, Ga, and S as the second quantum dot QD-G. The second quantum dot QD-G may be AgInxGa_{1-X}S₂, wherein 0.05≤X<1.

The second quantum dot QD-G may further include a ligand bound to the surface of a semiconductor compound structure. In one or more embodiments, the ligand may include an end group such as -NH₂, -NH₃⁺, -COOH, and/or -SH.

The second quantum dot QD-G, which is a multi-component quantum dot including Ag, In, Ga, and S, may receive source light and emit converted green light with a light-emitting center wavelength of about 500 nm to about 590 nm. In one or more embodiments, the light-emitting full width of half maximum of the converted green light, which is emitted by the second quantum dot QD-G and has a light-emitting center wavelength of about 500 nm to about 590 nm, may be less than about 40 nm.

The second quantum dot QD-G, which is a multi-component quantum dot, may be excellent or suitable in absorbance of the received source light. The second quantum dot QD-G may exhibit or provide a high absorbance for light in the range of about 430 nm to about 480 nm. For example, the second quantum dot QD-G may have a relatively high absorbance in the entire range of about 430 nm to about 480 nm without a significant decrease in absorbance (valley-free) in the wavelength range of about 430 nm to about 480 nm. In one or more embodiments, the second light control unit CCP-G including the second quantum dot QD-G may exhibit or provide excellent or suitable power conversion efficiency PCE. The power conversion efficiency PCE may correspond to the ratio of converted green light emitted by converting the wavelength of light-emitting blue light provided as source light by the second quantum dot QD-G. In one or more embodiments, the power conversion efficiency PCE may correspond to a conversion efficiency at the maximum light-emitting peak wavelength of the converted green light which is emitted by wavelength conversion of the second quantum dot QD-G if (e.g., when) blue light in the wavelength of about 450 nm is provided.

In the display device according to one or more embodiments of the present disclosure, because both light-emitting green light and light-emitting blue light are included in the source light, the overall light efficiency of the green light emitted from the light control layer CCL and finally displayed may include the power conversion efficiency PCE and the transmittance of the green light. In one or more embodiments, in order to increase or enhance the overall light efficiency of the green light, it is desired or required to maximize or increase the total amount of the green light in which the power conversion efficiency PCE of the converted green light and the transmittance of the transmitted green light are combined.

In the light control layer CCL according to one or more embodiments of the present disclosure, the power conversion efficiency PCE of the second light control unit CCP-G may be less than about 32% (e.g., about 10% to about 32%, about 15% to about 32%, about 20% to about 32%, about 22% to about 32%, or about 24% to about 32%). If (e.g., when) the power conversion efficiency PCE of the second light control unit CCP-G is less than about 32%, the sum of the power conversion efficiency and the light transmittance may be maximized, thereby increasing or enhancing the luminance of the display device.

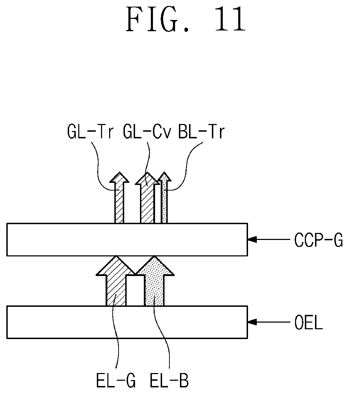

FIG. 11 schematically illustrates light extraction characteristics in a display device according to one or more embodiments of the present disclosure. FIG. 11 schematically illustrates only the light-emitting element OEL and the second light control unit CCP-G, which is a green light control unit, among the components of the display device in order to describe the light extraction characteristics.

As described with reference to FIGS. 7-9, in one or more embodiments, the light-emitting element OEL may emit source light including light-emitting green light EL-G and light-emitting blue light EL-B and provide the source light to the second light control unit CCP-G.

In the second light control unit CCP-G, one or more of the received source light may be wavelength-converted and emitted, and one or more of the received source light may be transmitted and emitted without wavelength conversion. The light-emitting blue light EL-B emitted from the light-emitting element OEL may be converted in the second light control unit CCP-G and emitted as a converted green light GL-Cv, or may be transmitted through the second light control unit CCP-G and emitted as a transmitted blue light BL-Tr. In one or more embodiments, one or more of the light-emitting blue light EL-B may not be wavelength-converted or transmitted and may be absorbed in the second light control unit CCP-G without being emitted, resulting in its extinction.

In one or more embodiments, the light-emitting green light EL-G emitted from the light-emitting element OEL may be transmitted through the second light control unit CCP-G and be emitted as a transmitted green light GL-Tr. In one or more embodiments, one or more of the light-emitting green light EL-G may not be transmitted and may be absorbed in the second light control unit CCP-G without being emitted, resulting in its extinction.

In one or more embodiments, in order to increase or enhance the efficiency of the light finally emitted through the second light control unit CCP-G, it is desired or required to increase the sum of the converted green light GL-Cv and the transmitted green light GL-Tr.

In the light control layer CCL according to one or more embodiments of the present disclosure as illustrated in FIG. 10, the thickness of the light control units CCP-R, CCP-G, and CCP-G may be about 2 µm to about 15 µm. For example, the thickness of the light control units CCP-R, CCP-G, and CCP-G may be about 5 µm to about 8 µm. If (e.g., when) the thickness of the light control units CCP-R, CCP-G, and CCP-G is less than about 2 µm, the power conversion efficiency PCE may be significantly or substantially reduced, and if (e.g., when) the thickness of the light control units CCP-R, CCP-G, and CCP-G exceeds about 15 µm, the transmittance may be reduced.

In one or more embodiments, the thickness of the second light control unit CCP-G may be about 2 µm to about 15 µm. For example, the thickness of the second light control unit CCP-G may be about 5 µm to about 8 µm.

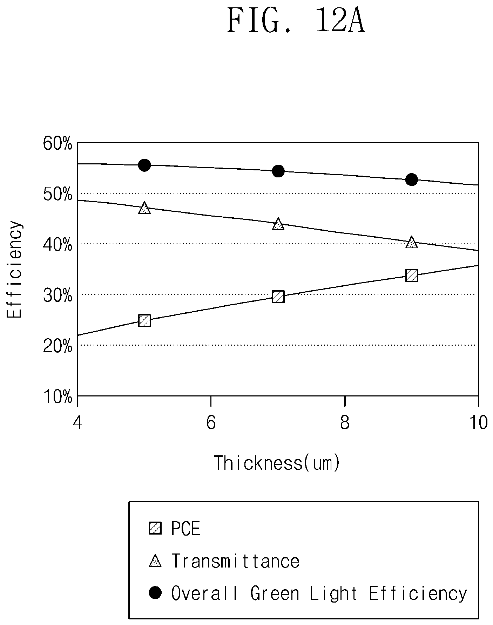

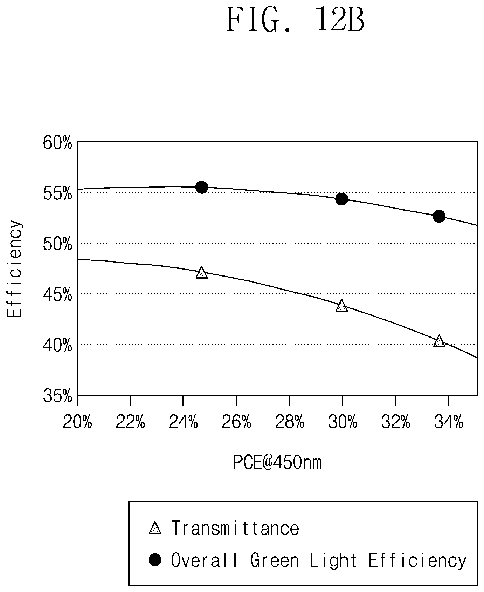

FIGS. 12A-12B are graphs illustrating the light efficiency characteristics of a light control unit according to thickness. FIG. 12A is a graph illustrating light efficiency according to the thickness of the light control layer, and FIG. 12B is a graph illustrating light efficiency according to power conversion efficiency.

The light efficiency characteristics evaluated and illustrated in FIGS. 12A-12B are for the second light control unit CCP-G (see FIG. 10) and correspond to a case in which the second light control unit CCP-G includes AgIn_{X}Ga_{1-X}S₂, wherein 0.05≤X<1, as the second quantum dot QD-G. The light efficiency characteristics evaluated and illustrated in FIGS. 12A-12B correspond to a case in which, in the second light control unit CCP-G, AgIn_{X}Ga_{1-X}S₂, wherein 0.05≤X<1, is included at about 20 wt% as the second quantum dot QD-G and TiO₂ is included at about 5 wt% as the scatterer SP.

Referring to FIG. 12A, as the thickness of the light control unit increases, the power conversion efficiency PCE increases and the transmittance decreases. The overall green light efficiency partially decreases as the thickness increases, but the overall green light efficiency exceeds approximately 50% across the entire thickness range as illustrated in the FIG. 12A.

FIG. 12B illustrates the relationship between transmittance and overall green light efficiency according to the power conversion efficiency PCE for 450 nm. When the power conversion efficiency PCE is less than about 32%, the transmittance is relatively high, and, in one or more embodiments, the overall green light efficiency is also high at around 55%.

Referring to FIGS. 12A-12B, when the second quantum dot GD-G is included at 20 wt%, the power conversion efficiency PCE appears to be less than about 32% in a case in which the thickness of the second light control unit CCP-G is in the range of about 5 µm to about 8 µm, and in one or more embodiments, it can be seen that, as good transmittance characteristics are exhibited, the overall green light efficiency appears to be high.

Referring again to FIG. 10, in one or more embodiments, the content (e.g., amount) of the second quantum dot QD-G included in the second light control unit CCP-G may be about 1 wt% to about 20 wt%. For example, the content (e.g., amount) of the second quantum dots QD-G included in the second light control unit CCP-G may be about 5 wt% to about 15 wt%. For example, the content (e.g., amount) of the second quantum dots QD-G included in the second light control unit CCP-G may be approximately 10 wt%. The content (e.g., amount) of the second quantum dot QD-G may correspond to the ratio of the weight of the second quantum dot QD-G to the total weight of all components included in the second light control unit CCP-G.

If (e.g., when) the content (e.g., amount) of the second quantum dot QD-G is less than about 1%, the power conversion efficiency PCE of the second light control unit CCP-G may significantly decrease, thereby reducing the light efficiency of the second light control unit CCP-G. In one or more embodiments, if (e.g., when) the content (e.g., amount) of the second quantum dot QD-G is more than 20%, the power conversion efficiency PCE may increase, but the transmittance may increase, and thus the final overall green light efficiency decreases.

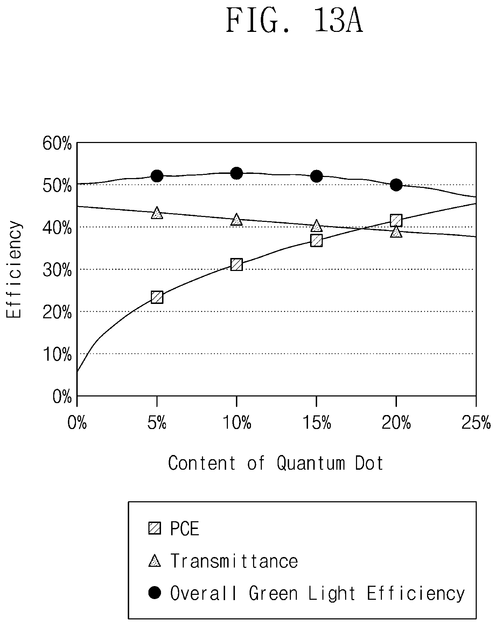

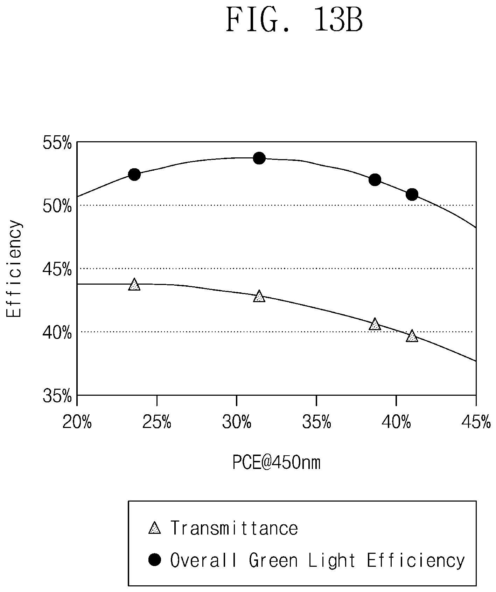

FIGS. 13A-13B are graphs illustrating light efficiency characteristics according to the content (e.g., amount) of quantum dots. FIG. 13A is a graph illustrating light efficiency according to the content (e.g., amount) of quantum dots included in the light control unit, and FIG. 13B is a graph illustrating light efficiency according to power conversion efficiency.

The light efficiency characteristics evaluated and illustrated in FIGS. 13A-13B are for the second light control unit CCP-G (see FIG. 10) and correspond to a case in which the second light control unit CCP-G includes AgIn_{X}Ga_{1-X}S₂, wherein 0.05≤X<1, as the second quantum dot QD-G. The light efficiency characteristics evaluated and illustrated in FIGS. 13A-13B correspond to a case in which the thickness of the second light control unit CCP-G is about 7 µm and TiO₂ is included at 5 wt% as the scatterer SP included in the second light control unit CCP-G.

Referring to FIG. 13A, as the content (e.g., amount) of quantum dots in the light control unit increases, the power conversion efficiency PCE increases and the transmittance decreases. The overall green light efficiency increases to an optimum level with an increase in the content (e.g., amount) of quantum dots, but subsequently decreases.

FIG. 13B illustrates the relationship between transmittance and overall green light efficiency according to the power conversion efficiency PCE for 450 nm. When the power conversion efficiency PCE is less than about 32%, the transmittance is relatively high, and, in one or more embodiments, the overall green light efficiency also appears to be high at about 50% and more.

Referring to FIGS. 13A-13B, when the thickness of the second light control unit CCP-G including the second quantum dot GD-G is about 7 µm, the power conversion efficiency PCE appears to be less than about 32% in a case in which the content (e.g., amount) of the second quantum dot included in the second light control unit CCP-G is in the range of about 5 wt% to about 10 wt%, and in one or more embodiments, it can be seen that, as good transmittance characteristics are exhibited, the overall green light efficiency appears to be high.

FIGS. 12A-12B illustrate light efficiency characteristics depending on the thickness of the light control unit when the content (e.g., amount) of the multi-component quantum dot included in the light control unit is set or fixed at 20 wt%, and the power conversion efficiency in the light control unit is less than about 32% in the specified thickness range, and in one or more embodiments, it can be seen that, as the transmittance increases, the overall green light efficiency appears to be high.

In one or more embodiments, FIGS. 13A-13B illustrate light efficiency characteristics according to the content (e.g., amount) of quantum dots included in the light control unit when the thickness of the light control unit is fixed or set at about 7 µm, and the power conversion efficiency of the light control unit in the set or predetermined content (e.g., amount) range of quantum dots is less than about 32%, and, in one or more embodiments, it can be seen that, as the transmittance increases, the overall green light efficiency appears to be high.

In one or more embodiments, referring to the results of FIGS. 12A-13B, when the power conversion efficiency PCE of the second light control unit (e.g., green light control unit) is less than about 32%, it can be seen that the overall green light efficiency of the second light control unit has a maximum value.

In one or more embodiments, if (e.g., when) the light control unit includes a multi-component quantum dot including Ag, In, Ga, and S, the light control layer according to one or more embodiments of the present disclosure may exhibit or provide characteristics in which the overall light efficiency increases as a result of making the power conversion efficiency PCE of the light control unit less than about 32%. In one or more embodiments, as the multi-component quantum dot including Ag, In, Ga, and S has a high light absorption rate for source light, the light efficiency of the light control unit including the quantum dot including Ag, In, Ga, and S may further increase.

In one or more embodiments, because the display device according to one or more embodiments of the present disclosure, which includes a display layer that provides source light including light-emitting green light and light-emitting blue light, includes a light control layer in which a green light control unit has a power conversion efficiency PCE of less than about 32%, the final light efficiency of the green light may increase or enhance, thereby being able to exhibit or provide relatively high luminance characteristics.

The display device according to one or more embodiments of the present disclosure may exhibit or provide improved or enhanced overall light efficiency by optimizing power conversion efficiency and light transmittance by reducing the power conversion efficiency of quantum dots to less than about 32% in the green light control unit that receives source light and emits green light.

The display device according to one or more embodiments of the present disclosure may include a light-emitting element that emits green light and blue light and a light control unit including quantum dots having relatively high absorbance, and by increasing or enhancing the light transmittance in the light control unit through controlling the power conversion efficiency of the quantum dots in the light control unit to a set or predetermined value or below, the final overall light efficiency may be increased or enhanced, thereby being able to exhibit or provide relatively high luminance characteristics.

One or more embodiments of the present disclosure provide an electronic device including the display device as described in one or more embodiments.

In one or more embodiments, the electronic device may be a smartphone, a television, a monitor, a tablet, an electric vehicle, a mobile phone, a tablet personal computer (PC), a mobile communication terminal, an electronic notebook, an electronic book, a portable multimedia player (PMP), a navigation device, an ultra-mobile PC (UMPC), a laptop computer, a billboard, an Internet of Things (IoT) device, a smartwatch, a watch phone, and/or a head-mounted display (HMD).

Although one or more embodiments of the present disclosure have been described with reference to the accompanying drawings, it should be understood that the present disclosure should not be limited to these embodiments but one or more suitable modifications and changes can be made by one ordinary skilled in the art within the scope of the appended claims and equivalents thereof, the detailed description of the present disclosure, and the accompanying drawings.

Therefore, the present disclosure is not limited to the embodiments as described, but the scope of the present disclosure should be determined by the appended claims and equivalents thereof.

## Claims

1. A display device, comprising:
a light-emitting element that outputs source light; and
a light control layer on the light-emitting element, wherein the light control layer transmits the source light or converts a wavelength of the source light,
wherein the light-emitting element comprises:
a first electrode;
a second electrode facing the first electrode;
at least one green light-emitting structure between the first electrode and the second electrode; and
at least one blue light-emitting structure between the first electrode and the second electrode,
wherein the light control layer comprises a green light control part comprising a green quantum dot that converts a wavelength of light emitted from the light-emitting element and emits green light,
wherein:
a power conversion efficiency of the green light control part is less than about 32%; and
the power conversion efficiency is a conversion efficiency at the maximum light-emitting peak wavelength of light emitted by exciting the green quantum dot with light of a wavelength of about 450 nm.

2. The display device as claimed in claim 1, wherein the green quantum dot is a multi-component quantum dot comprising Ag, In, Ga, and S.

3. The display device as claimed in claim 2, wherein the green quantum dot is AgIn_{X}Ga_{1-X}S₂, wherein 0.05≤X<1.

4. The display device as claimed in claim 2 or claim 3, wherein:
a light-emitting center wavelength of the green light converted and emitted by the green quantum dot is about 500 nm to about 590 nm; and
a light-emitting full width of half maximum is about 40 nm or less.

5. The display device as claimed in any one of claims 2 to 4, wherein an average diameter of the green quantum dot is about 3 nm or more.

6. The display device as claimed in any one of claims 1 to 5, wherein:
each of the at least one green light-emitting structure and the at least one blue light-emitting structure comprises a hole transport region, a light-emitting layer, and an electron transport region; and
the light-emitting element further comprises a charge generation layer between the at least one green light-emitting structure and the at least one blue light-emitting structure.

7. The display device as claimed in any one of claims 1 to 6, wherein the light-emitting element further comprises a first light-emitting structure, a second light-emitting structure, a third light-emitting structure, a fourth light-emitting structure, and a fifth light-emitting structure that are sequentially provided in the direction of the light control layer and charge generation layers between the first light-emitting structure, the second light-emitting structure, the third light-emitting structure, the fourth light-emitting structure, and the fifth light-emitting structure, which are between the first electrode and the second electrode,
wherein, at least one selected from among the first light-emitting structure, the second light-emitting structure, the third light-emitting structure, the fourth light-emitting structure, and the fifth light-emitting structure is a green light-emitting structure, and the remaining light-emitting structures are blue light-emitting structures.

8. The display device as claimed in any one of claims 1 to 7, wherein:
(i) a thickness of the green light control part is about 2 µm to about 15 µm; and/or
(ii) a content of the green quantum dot in the green light control part is about 1 wt% to about 20 wt%.

9. A display device, comprising:
a display layer that provides source light comprising light-emitting green light and light-emitting blue light; and
a light control layer on the display layer, wherein the light control layer comprises a first light control part, a second light control part, and a third light control part that are divided from each other on a plane,
wherein:
the first light control part comprises a red quantum dot that converts a wavelength of the source light into converted red light; and
the second light control part comprises a green quantum dot that converts a wavelength of the source light into converted green light,
wherein:
a power conversion efficiency of the second light control part is less than about 32%; and
the power conversion efficiency is a conversion efficiency at the maximum light-emitting peak wavelength of light emitted by exciting the green quantum dot with light of a wavelength of about 450 nm.

10. The display device as claimed in claim 9, wherein the green quantum dot is AgIn_{X}Ga_{1-X}S₂, wherein 0.05≤X<1.

11. The display device as claimed in claim 10, wherein a content of the green quantum dot in the second light control part is about 1 wt% to about 20 wt%.

12. The display device as claimed in claim 10 or claim 11, wherein a thickness of the second light control part is about 2 µm to about 15 µm.

13. The display device as claimed in any one of claims 10 to 12, wherein:
(i) the red quantum dot comprises In and P; and/or
(ii) the display layer comprises a light-emitting element comprising at least one green light-emitting layer that emits the light-emitting green light and at least one blue light-emitting layer that emits the light-emitting blue light, which are stacked in a thickness direction; and/or
(iii) the third light control part transmits the source light and does not comprise a quantum dot; and/or
(iv) light emitted from the second light control part comprises the converted green light and the light-emitting green light.

14. An electronic device, comprising:
a red light-emitting region, a green light-emitting region, and a blue light-emitting region that are divided from each other on a plane,
a display panel comprising a light-emitting element that comprises a green light-emitting structure and a blue light-emitting structure stacked in a thickness direction and emits source light; and
a light control panel on the display panel, wherein the light control panel comprises a light control layer which comprises a first light control part that corresponds to the red light-emitting region, a second light control part that corresponds to the green light-emitting region, and a third light control part that corresponds to the blue light-emitting region,
wherein:
the second light control part converts the wavelength of the source light or transmits the source light and emits green light;
a power conversion efficiency of the second light control part is less than about 32%; and
the power conversion efficiency is a conversion efficiency at the maximum light-emitting peak wavelength of light wavelength-converted and emitted by exciting the green quantum dot with light of a wavelength of about 450 nm.

15. The electronic device as claimed in claim 14, wherein:
(i) the second light control part comprises a green quantum dot having a chemical formula of AgIn_{X}Ga_{1-X}S₂, wherein 0.05≤X<1; and/or
(ii) the light control panel further comprises a color filter layer above the light control layer; and/or
(iii) the electronic device is a television, an external billboard, a monitor, a mobile phone, a tablet, a navigation system, or a game console.
